# EUROPEAN PATENT APPLICATION

(11) **EP 4 683 453 A1**
(43) Date of publication of application: **21.01.2026**
(21) Application number: 24770577.5
(22) Date of filing: 01.03.2024
(51) Int. Cl.: H10B 61/00, H10N 50/10

(54) **STORAGE ELEMENT, STORAGE DEVICE, AND ELECTRONIC DEVICE**

(30) Priority: 13.03.2023 JP 2023038915
(71) Applicant: Sony Semiconductor Solutions Corporation, Atsugi-shi, Kanagawa 243-0014 (JP)
(72) Inventor: SATO, Yo, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/007802
(87) International publication number: WO 2024/190466

(57) **Abstract**

Provided is a storage element including a stacked structure in which a storage layer whose magnetization direction can be reversed, a separation layer, a first magnetic layer, an antiparallel binding layer, and a second magnetic layer are stacked in this order.

## Description

### Field

The present disclosure relates to a storage element, a storage device, and an electronic device.

### Background

Along with the rapid development of various information devices from large-capacity servers to mobile terminals, further improvement in performance such as more integration, higher speed, and lower power consumption has been pursued in elements such as memories and logics included in the information devices. Particularly, the progress of a nonvolatile semiconductor memory is remarkable, and for example, a flash memory as a large-capacity file memory is spreading at a speed of expelling hard disk drives. On the other hand, in consideration of application to code storage applications and working memories, various types of semiconductor memories such as magnetic random access memories (MRAMs) are being developed in order to replace NOR flash memories, dynamic random access memories (DRAMs), and the like that are currently generally used. Some of them have already been put to practical use.

An MRAM stores information by using a change in the electric resistance by changing the magnetization state of a magnetic material of a magnetic storage element included in the MRAM. Therefore, the stored information can be read by determining the resistance state of the magnetic storage element determined by the change in the magnetization state, specifically, the magnitude of the electric resistance of the magnetic storage element.

Moreover, in the MRAM, since information is stored by the magnetization state of the magnetic storage element as described above, the stability of storage or the like may deteriorate due to the influence of an external magnetic field. Therefore, in order to suppress an influence of such an external magnetic field, in the following Patent Literature 1, a magnetic shield made of a magnetic material having high magnetic permeability is provided in such a manner as to cover the entire MRAM. In addition, for example, in Patent Literature 2 below, magnetic shields are provided above and below an MRAM chip in such a manner as to sandwich the chip.

### Citation List

### Patent Literatures

Patent Literature 1: JP 2015-53450 A
Patent Literature 2: JP 2014-112691 A

### Summary

### Technical Problem

However, in a case where the magnetic shields are provided in such a manner as to cover the entire MRAM or above and below the chip, it is also necessary to increase the film thickness of the magnetic material included in the magnetic shield, and it becomes difficult to suppress an increase in the manufacturing cost of the MRAM or an increase in the volume of a package of the MRAM.

Therefore, the present disclosure proposes a storage element, a storage device, and an electronic device capable of suppressing an increase in the manufacturing cost or the volume while effectively suppressing an influence of an external magnetic field.

### Solution to Problem

According to the present disclosure, there is provided a storage element including: a stacked structure in which a storage layer whose magnetization direction can be reversed, a separation layer, a first magnetic layer, an antiparallel binding layer, and a second magnetic layer are stacked in this order.

Furthermore, according to the present disclosure, there is provided a storage device including: a plurality of storage elements two-dimensionally arranged in an array shape. In the storage device, each of the storage elements includes: a stacked structure in which a storage layer whose magnetization direction can be reversed, a separation layer, a first magnetic layer, an antiparallel binding layer, and a second magnetic layer are stacked in this order.

Furthermore, according to the present disclosure, there is provided an electronic device mounted with a storage device including a plurality of storage elements two-dimensionally arranged in an array shape. In the storage device, each of the storage elements includes: a stacked structure in which a storage layer whose magnetization direction can be reversed, a separation layer, a first magnetic layer, an antiparallel binding layer, and a second magnetic layer are stacked in this order.

### Brief Description of Drawings

FIG. 1 is an explanatory diagram schematically illustrating a stacked structure of an MTJ element.
FIG. 2 is a cross-sectional view illustrating an example of an MTJ element according to a first embodiment of the present disclosure.
FIG. 3 is a cross-sectional view and a plane view illustrating an example of the MTJ element according to the first embodiment of the disclosure.
FIG. 4 is an explanatory diagram for explaining the operation of the MTJ element of the first embodiment of the disclosure.
FIG. 5 is an explanatory diagram for explaining simulation results of the MTJ element of the first embodiment of the disclosure (part 1).
FIG. 6 is an explanatory diagram for explaining simulation results of the MTJ element of the first embodiment of the disclosure (part 2).
FIG. 7 is a cross-sectional view illustrating an MTJ element according to a first modification of the first embodiment of the disclosure.
FIG. 8 is a cross-sectional view and a plane view illustrating an MTJ element according to a second modification of the first embodiment of the disclosure.
FIG. 9 is a cross-sectional view illustrating an example of an MTJ element according to a second embodiment of the present disclosure.
FIG. 10 is a cross-sectional view illustrating an example of an MTJ element according to a third embodiment of the present disclosure.
FIG. 11 is a cross-sectional view and a plane view illustrating an example of an MTJ element according to a fourth embodiment of the disclosure.
FIG. 12 is a cross-sectional view illustrating a manufacturing method of an MTJ element according to a fifth embodiment of the disclosure (part 1).
FIG. 13 is a cross-sectional view illustrating the manufacturing method of the MTJ element according to the fifth embodiment of the disclosure (part 2).
FIG. 14 is a cross-sectional view illustrating the manufacturing method of the MTJ element according to the fifth embodiment of the disclosure (part 3).
FIG. 15 is a cross-sectional view illustrating the manufacturing method of the MTJ element according to the fifth embodiment of the disclosure (part 4).
FIG. 16 is a cross-sectional view illustrating the manufacturing method of the MTJ element according to the fifth embodiment of the disclosure (part 5).
FIG. 17 is a cross-sectional view illustrating the manufacturing method of the MTJ element according to the fifth embodiment of the disclosure (part 6).
FIG. 18 is an explanatory diagram illustrating an exemplary schematic configuration of a storage device according to a sixth embodiment of the disclosure.
FIG. 19 is a diagram illustrating an exemplary schematic configuration of a memory cell array according to the sixth embodiment of the disclosure.
FIG. 20 is an explanatory diagram illustrating an exemplary stacked structure of an imaging device to which the technology according to the disclosure can be applied.
FIG. 21 is an explanatory diagram illustrating an example of a schematic functional configuration of a camera to which the technology according to the present disclosure can be applied.
FIG. 22 is a block diagram illustrating an example of a schematic functional configuration of a smartphone to which the technology according to the present disclosure can be applied.
FIG. 23 is a block diagram illustrating a configuration example of a vehicle control system as an example of a mobile device control system to which the technology of the present disclosure is applied.
FIG. 24 is a diagram illustrating an example of sensing regions.

### Description of Embodiments

Hereinafter, preferred embodiments of the present disclosure will be described in detail by referring to the accompanying drawings. Note that, in the present specification and the drawings, components having substantially the same functional configuration are denoted by the same symbols, and redundant description is omitted. Meanwhile, a plurality of components having substantially the same or similar functional configurations may be distinguished by attaching different alphabets after the same symbol in the present specification and the drawings. However, in a case where it is not particularly necessary to distinguish each of the plurality of components having substantially the same or similar functional configurations, only the same symbol is attached.

In addition, the drawings referred to in the following description are for describing and facilitating understanding of an embodiment of the disclosure, and shapes, dimensions, ratios, and the like illustrated in the drawings may be different from actual ones for the sake of facilitating understanding. Furthermore, an imaging device illustrated in the drawings can be modified in design as appropriate in consideration of the following description and known technology.

The description of specific lengths or shapes in the following description does not mean only the same values as mathematically defined numerical values or the same shape as geometrically defined shapes. Specifically, the description of a specific length or shape in the following description includes a case where there is an allowable difference (error or distortion) in storage elements, storage devices, or use or operation thereof as well as a shape similar to the shape thereof.

In the following description of circuits (electrical connection), unless otherwise specified, "electrically connected" means that a plurality of elements is connected such that electricity (signal) is conducted. In addition, "electrically connected" in the following description includes not only a case where a plurality of elements is directly and electrically connected but also a case where a plurality of elements is indirectly and electrically connected via other elements.

Note that the description will be given in the following order.
1. Background of Elaboration of Embodiment of Present Disclosure
   1.1 MTJ Element
   1.2 Background
2. First Embodiment
   2.1 Configuration
   2.2 Operation
   2.3 Simulation Result
   2.4 First Modification
   2.5 Second Modification
3. Second Embodiment
4. Third Embodiment
5. Fourth Embodiment
6. Fifth Embodiment
7. Sixth Embodiment
8. Summary
9. Application Examples
   9.1 Application Example to Camera
   9.2 Application Example to Smartphone
   9.3 Application Example to Mobile Device Control System
10. Supplements

### <<1. Background of Elaboration of Embodiment of Present Disclosure>>

First, before describing the embodiment of the disclosure, the background that led to creation of the embodiment of the disclosure by the present inventor will be described.

### <1.1 MTJ Element>

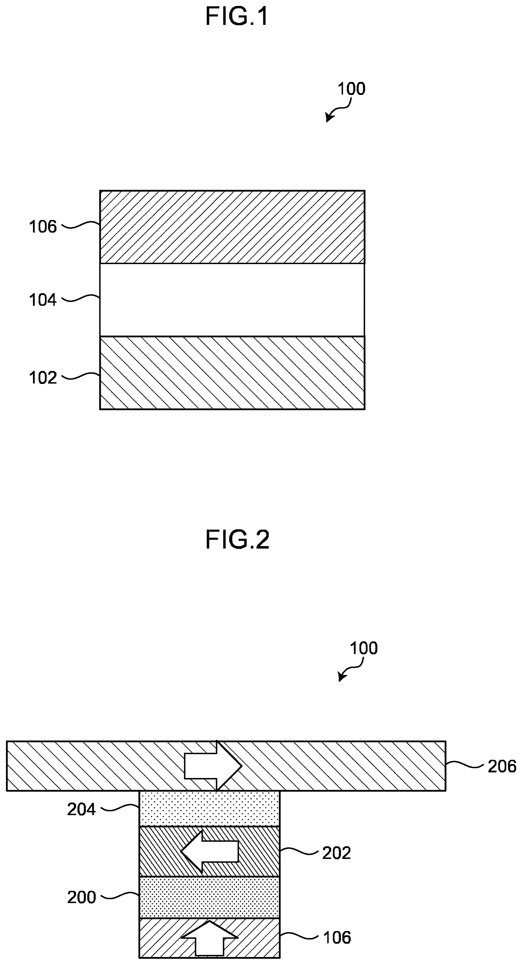

First, a basic structure of an MTJ element 100 which is a magnetic storage element of an MRAM (storage device) will be described with reference to FIG. 1. FIG. 1 is an explanatory diagram schematically illustrating a stacked structure of the MTJ element 100.

As described above, an MRAM utilizes the fact that the electric resistance changes as the magnetization state of a magnetic material of the MTJ element 100 changes, to store information. Therefore, the stored information can be read by determining the resistance state of the MTJ element 100 determined by the change in the magnetization state, specifically, the magnitude of the electric resistance of the MTJ element 100. That is, the MTJ element 100 is a magnetic storage element that stores one piece of information (1 or 0).

Wires for the address (namely, word lines and bit lines) (not illustrated) orthogonal to each other are provided above and below the MTJ element 100, and the MTJ element 100 is connected to a word line and a bit line in the vicinity of an intersection of these wires. Note that details of an array of a plurality of MTJ elements 100 will be described later.

Specifically, as illustrated in FIG. 1, the MTJ element 100 has a structure in which a fixed layer 102 in which the magnetic moment is fixed in a predetermined direction, a nonmagnetic layer 104, a storage layer 106 in which the direction of the magnetic moment is variable, and a cap layer (not illustrated) are sequentially stacked on a base layer (not illustrated). Note that the MTJ element 100 is not limited to being stacked in the order illustrated in FIG. 1, and for example, the storage layer 106 may be stacked on the base layer, the nonmagnetic layer 104 may be stacked on the storage layer 106, and the fixed layer 102 may be sequentially stacked on the nonmagnetic layer 104.

Specifically, the fixed layer 102 is formed of a magnetic material containing a ferromagnetic material, and the direction of the magnetic moment (magnetization direction) is fixed by a high coercive force. The nonmagnetic layer 104 is formed of various nonmagnetic materials such as magnesium oxide (MgO) and is provided between the fixed layer 102 and the storage layer 106. The storage layer 106 is formed of a magnetic material containing a ferromagnetic material and can change (reverse) the direction of the magnetic moment (magnetization direction) in accordance with information to be stored. Furthermore, the base layer and the cap layer can function as an electrode, a control film of crystal orientation, a protective film, or the like.

In the MTJ element 100, by applying the voltage to the MTJ element 100 to change the direction of the magnetic moment of the storage layer 106, the resistance value of the entire MTJ element 100 changes due to a difference from the direction of the magnetic moment of the fixed layer 102. Specifically, in a case where the directions of the magnetic moments of the fixed layer 102 and the storage layer 106 are the same, the resistance value of the MTJ element 100 is low, and in a case where the directions of the magnetic moments of the fixed layer 102 and the storage layer 106 are different, the resistance value of the MTJ element 100 is high. Moreover, the MTJ element 100 can store information using a change in the resistance value due to such a change in the magnetic moment.

Furthermore, the MTJ element 100 is sandwiched between an upper electrode (not illustrated) and a lower electrode (not illustrated) and is electrically connected to a word line, a bit line, a signal line (not illustrated), a selection transistor (not illustrated), and the like via these electrodes. Specifically, the fixed layer 102 of the MTJ element 100 is electrically connected with the word line and the signal line via the lower electrode and the selection transistor, and the storage layer 106 of the MTJ element 100 is electrically connected with the bit line via the upper electrode. As a result, in the MTJ element 100 selected by the selection transistor, a voltage is applied between the lower electrode and the upper electrode of the MTJ element 100 via the signal line and the bit line, whereby information is written to and read from the storage layer 106 of the MTJ element 100.

### <1.2 Background>

Next, the background that led the present inventor to elaborate the embodiment of the disclosure will be described. In an MRAM (storage device), since information is stored by such an MTJ element 100 as described above, the stability of storage and the like may be deteriorated by an external magnetic field. Specifically, the direction of the magnetic moment of the magnetic material constituting the storage layer 106 of the MTJ element 100 may change under the influence of the external magnetic field. Therefore, there occurs the phenomenon that the direction of the magnetic moment of the storage layer 106 deviates from the direction of the magnetic moment corresponding to stored information, and thus the storage holding capability of the MRAM decreases. In addition, the external magnetic field makes it difficult to change the direction of the magnetic moment of the storage layer 106 in such a manner as to correspond to information to be stored, and an increase in the storage voltage or the like of the MRAM occurs.

Therefore, in order to suppress the influence of such an external magnetic field, in the related art, a magnetic shield made of a magnetic material having high magnetic permeability is provided. For example, in Patent Literature 1 described above, the magnetic shield is provided in such a manner as to cover the entire MRAM. Furthermore, for example, in Patent Literature 2 described above, the magnetic shields are provided above and below the chip in such a manner as to sandwich the chip provided with an MTJ element 100.

However, in a case where the magnetic shields are provided in such a manner as to cover the entire MRAM or above and below the chip, it is also necessary to increase the film thickness of the magnetic material included in the magnetic shield, and it becomes difficult to suppress an increase in the manufacturing cost of the MRAM or an increase in the volume of a package of the MRAM. Furthermore, for example, in a case where the chip of the MRAM and a chip of an image sensor are stacked, a magnetic material shield cannot be installed on a light-receiving surface side of the image sensor due to a need to transmit light. Therefore, in such a case, since a magnetic shield is disposed only at a position other than the light-receiving surface, the shielding effect for external magnetic fields by the magnetic shield is greatly reduced.

Therefore, in view of such a situation, the present inventor has intensively studied, and conceived of an idea of providing a layer for suppressing the influence of an external magnetic field in the MTJ element 100, and created the embodiment of the disclosure. According to the embodiment of the disclosure created by the present inventor, it is possible to suppress an increase in the manufacturing cost or the volume of the MRAM while suppressing an influence from an external magnetic field. Furthermore, since the embodiment of the disclosure does not entirely cover with the magnetic shield, the embodiment of the disclosure can be applied to a stacked structure with a chip of an image sensor whose light-receiving surface cannot be covered. Hereinafter, details of the embodiment of the disclosure will be described in order.

### <<2. First Embodiment>>

### <2.1 Configuration>

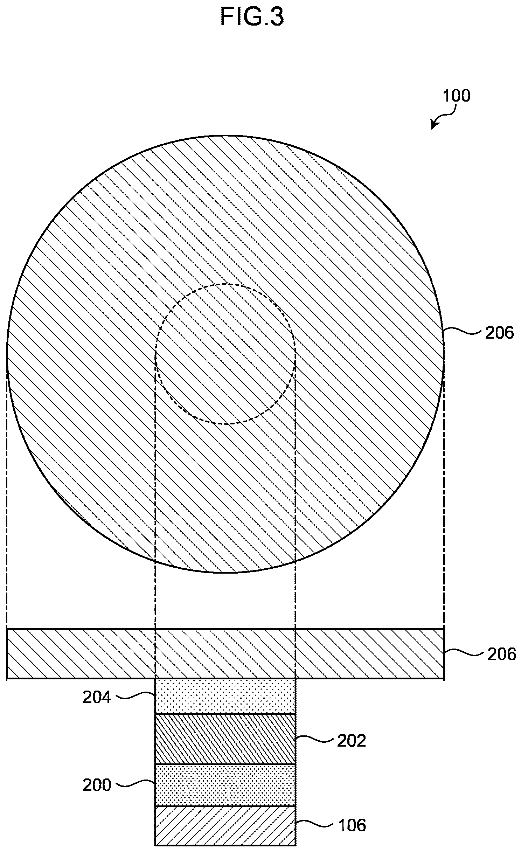

First, the configuration of an MTJ element 100 according to a first embodiment of the disclosure will be described with reference to FIGS. 2 and 3. FIG. 2 is a cross-sectional view illustrating an example of the MTJ element 100 according to the present embodiment, and FIG. 3 is a cross-sectional view and a plane view illustrating an example of the MTJ element 100 according to the present embodiment. Note that, in FIG. 2, an example of the direction of the magnetic moment of each layer of the MTJ element 100 in a state where no external magnetic field is applied is indicated by an arrow.

As illustrated in FIG. 2, the MTJ element 100 of the embodiment has a structure in which, for example, a separation layer 200, a magnetic layer (first magnetic layer) 202, an antiparallel binding layer 204, and a magnetic layer (second magnetic layer) 206 are sequentially stacked on a storage layer 106. In other words, the MTJ element 100 of the embodiment has a stacked structure in which the separation layer 200 is provided on the storage layer 106, the magnetic layer 202 is provided on the separation layer 200, the antiparallel binding layer 204 is provided on the magnetic layer 202, and the magnetic layer 206 is provided on the antiparallel binding layer 204. Note that, in an embodiment of the disclosure, as described later, the MTJ element 100 is only required to have a structure in which the storage layer 106, the separation layer 200, the magnetic layer 202, the antiparallel binding layer 204, and the magnetic layer 206 are sequentially stacked, and the order in the stacking direction is not particularly limited. That is, in an embodiment of the disclosure, the MTJ element 100 is not limited to that the layers are stacked in the order illustrated in FIG. 2.

In FIG. 2, only the storage layer 106 is illustrated to facilitate understanding. However, actually, it is based on the premise that a nonmagnetic layer (insulator layer) 104 is stacked under the storage layer 106, and the fixed layer (reference layer) 102 is further stacked under the nonmagnetic layer 104. In other words, the fixed layer 102 is provided on the opposite side of the separation layer 200 with respect to the storage layer 106, and the nonmagnetic layer 104 is sandwiched by the storage layer 106 and the fixed layer 102. Alternatively, although only the storage layer 106 is illustrated in FIG. 2, actually, the fixed layer 102 may be stacked under the separation layer 200, the nonmagnetic layer 104 may be stacked under the fixed layer 102, and the storage layer 106 may be stacked under the nonmagnetic layer 104. In other words, the fixed layer 102 is provided on the separation layer 200 side with respect to the storage layer 106, and the nonmagnetic layer 104 is sandwiched by the storage layer 106 and the fixed layer 102.

That is, the storage layer 106 in FIG. 2 represents a stacked structure in which the fixed layer 102, the nonmagnetic layer 104, and the storage layer 106 are sequentially stacked from the lower side in FIG. 2, or a stacked structure in which the storage layer 106, the nonmagnetic layer 104, and the fixed layer 102 are sequentially stacked from the lower side in FIG. 2. The fixed layer 102 is formed of a magnetic material containing a ferromagnetic material, and the direction of the magnetic moment is fixed by a high coercive force or the like also in FIG. 2 as described above. The nonmagnetic layer 104 is formed of various nonmagnetic materials such as magnesium oxide. In addition, the storage layer 106 is formed of a magnetic material containing a ferromagnetic material, and the direction of the magnetic moment can be changed depending on information to be stored.

Although not illustrated in FIG. 2, the storage layer 106 may be provided on a base layer (not illustrated), and a cap layer (not illustrated) may be further provided on the storage layer 106. The base layer and the cap layer can function as an electrode, a control film of crystal orientation, a protective film, or the like. Furthermore, the MTJ element 100 having a stacked structure as illustrated in FIG. 2 is sandwiched between an upper electrode (not illustrated) and a lower electrode (not illustrated) (a pair of electrodes).

Each layer of the MTJ element 100 will be further described. First, the separation layer 200 has a function of suppressing the influence, on the storage layer 106, of the magnetic moment of each layer on and above the separation layer 200. Specifically, the separation layer 200 is formed of a nonmagnetic material having conductivity. The separation layer 200 can contain, for example, at least one selected from the group consisting of copper (Cu), tantalum (Ta), tantalum nitride (TaN), ruthenium (Ru), zirconium (Zr), iridium (Ir), chromium (Cr), tungsten (W), molybdenum (Mo), platinum (Pt), palladium (Pd), aluminum (Al), silicon (Si), cobalt iron boron (CoFeB), and the like. Furthermore, the separation layer 200 has a film thickness of greater than or equal to 1 nm and less than 10 nm.

The magnetic layer 202 is magnetically coupled with the magnetic layer 206 by the antiparallel binding layer 204 to be described later in such a manner that the direction of the magnetic moment thereof is opposite to that of the magnetic layer 206. Furthermore, the magnetic layer 202 can cancel at least a part of the magnetic moment of an external magnetic field by its own magnetization moment and has a function of suppressing the influence of the magnetic moment of the external magnetic field on the storage layer 106. Note that details of the operation of the magnetic layer 202 will be described later.

Specifically, the magnetic layer 202 has perpendicular magnetic anisotropy having an intensity not exceeding a demagnetizing field of each layer included in the stacked structure of the MTJ element 100 and is formed of a ferromagnetic material. The magnetic layer 202 can contain, for example, at least one ferromagnetic material selected from the group consisting of cobalt platinum (CoPt), cobalt nickel (CoNi), CoFeB, cobalt iron (CoFe), nickel iron (NiFe), and the like. In addition, it is preferable for the magnetic layer 202 to have a film thickness within a range of 1 nm to 3 nm.

The antiparallel binding layer 204 can make the directions of the magnetic moments of a pair of layers of magnetic materials sandwiching the antiparallel binding layer opposite to each other. Specifically, the antiparallel binding layer 204 has a function of magnetically coupling the magnetic layer 202 with the magnetic layer 206 in such a manner that the direction of the magnetic moment is opposite to the direction of the magnetic layer 206. The antiparallel binding layer 204 can contain at least one element selected from the group consisting of Ru, Ir, osmium (Os), and the like. The antiparallel binding layer 204 has a film thickness of greater than or equal to 3 angstroms and less than 15 angstroms.

Furthermore, the magnetic layer 206 has a function of causing the direction of its own magnetic moment to be the same direction as the direction of the magnetic moment of the external magnetic field under the influence of an external magnetic field. The magnetic layer 206 has perpendicular magnetic anisotropy having an intensity not exceeding a demagnetizing field of each layer included in the stacked structure of the MTJ element 100 and is formed of a ferromagnetic material. The magnetic layer 206 can include, for example, at least one ferromagnetic material selected from the group consisting of CoPt, CoNi, CoFeB, CoFe, NiFe, and the like. In addition, it is preferable for the magnetic layer 206 to have a film thickness within a range of 3 nm to 6 nm. In addition, the film thickness of the magnetic layer 206 is preferably the same as the film thickness of the magnetic layer 202 or thicker than the film thickness of the magnetic layer 202. Then, the magnetic layer 206 may function as the above-described upper electrode by being formed of a material having conductivity.

Then, under the influence of the external magnetic field, in the magnetic layer 206, the direction of its own magnetic moment attempts to be the same as the direction of the magnetic moment of the external magnetic field. Furthermore, since the magnetic layer 202 described above is magnetically coupled by the antiparallel binding layer 204 in such a manner as to have a direction of the magnetic moment in the opposite direction to that of the magnetic layer 206, the direction of its own magnetic moment attempts to be in the opposite direction to the direction of the magnetic moment of the magnetic layer 206. Then, since at least a part of the magnetic moment of the external magnetic field is canceled by the magnetization moment of the magnetic layer 202 close to the storage layer 106, the influence of the magnetic moment of the external magnetic field is suppressed in the storage layer 106. Note that details of the operation of each layer of the MTJ element 100 will be described later.

Furthermore, for example, as illustrated in the cross-sectional view illustrated in the lower part of FIG. 3, in order to suppress the influence of the magnetic layer 206 from directly affecting the storage layer 106, it is preferable that the area of the magnetic layer 206 be larger than that of the magnetic layer 202 in a cross section taken along a plane perpendicular to the stacking direction of the stacked structure. That is, in the present embodiment, when the MTJ element 100 is viewed from above, the magnetic layer 206 preferably covers the magnetic layer 202 and the storage layer 106 entirely. Further specifically, in the present embodiment, for example, the area of the magnetic layer 206 is preferably nine or more times the area of the magnetic layer 202 in the cross section.

In the present embodiment, by making the area of the magnetic layer 206 wider than that of the magnetic layer 202, the end of the magnetic layer 206 can be disposed farther from the storage layer 106. As a result, in the present embodiment, the leakage magnetism from the magnetic layer 206 can be suppressed from reaching the storage layer 106, and the influence from the magnetic layer 202 can be efficiently exerted on the storage layer 106.

Furthermore, for example, as illustrated in the top view illustrated in the upper part of FIG. 3, it is preferable that the stacked layers including the storage layer 106, the separation layer 200, the magnetic layer 202, and the antiparallel binding layer 204 have a substantially circular shape in a cross section taken along a plane perpendicular to the stacking direction of the stacked structure. Furthermore, for example, the magnetic layer 206 has a substantially circular shape in a cross section taken along a plane perpendicular to the stacking direction of the stacked structure. Note that the substantially circular shape mentioned here includes a circular shape or an elliptical shape.

### <2.2 Operation>

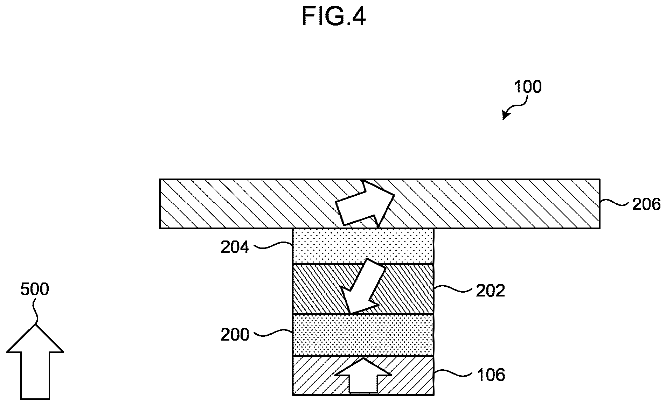

Next, the operation of the MTJ element 100 of the embodiment will be described with reference to FIG. 4. FIG. 4 is an explanatory diagram for explaining the operation of the MTJ element 100 of the present embodiment. Note that, in FIG. 4, an example of the direction of the magnetic moment of each layer of the MTJ element 100 in a state where an external magnetic field 500 is applied is indicated by an arrow. It is also based on the premise that the external magnetic field 500 has a magnetic moment acting from the bottom to the top in FIG. 4.

When the external magnetic field 500 is applied, due to the influence of the external magnetic field 500, in the magnetic layer 206, the direction of its own magnetic moment attempts to be the same as the direction of the magnetic moment of the external magnetic field 500. That is, the direction of the magnetic moment of the magnetic layer 206 changes from the state illustrated in FIG. 2 to the state illustrated in FIG. 4.

Next, since the magnetic layer 202 is magnetically coupled by the antiparallel binding layer 204 in such a manner as to have a direction of the magnetic moment in the opposite direction to that of the magnetic layer 206, the direction of its own magnetic moment attempts to change to be opposite to the direction of the magnetic moment of the magnetic layer 206. That is, the direction of the magnetic moment of the magnetic layer 202 changes from the state illustrated in FIG. 2 to the state illustrated in FIG. 4.

Then, since at least a part of the magnetic moment of the external magnetic field 500 is canceled by the magnetization moment of the magnetic layer 202, the influence from the magnetic moment of the external magnetic field 500 is suppressed in the storage layer 106.

### <2.3 Simulation Result>

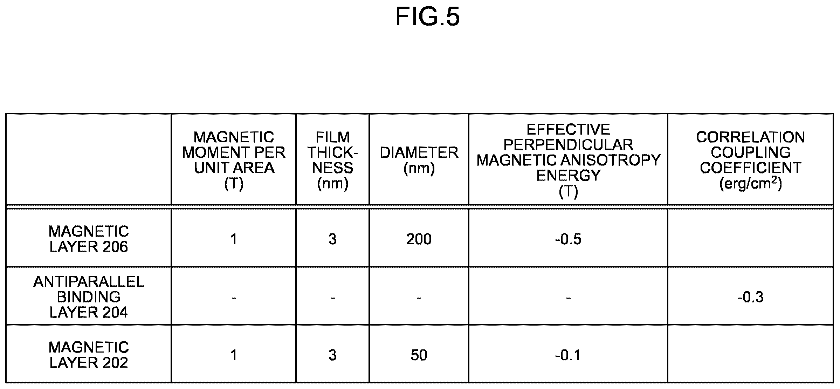

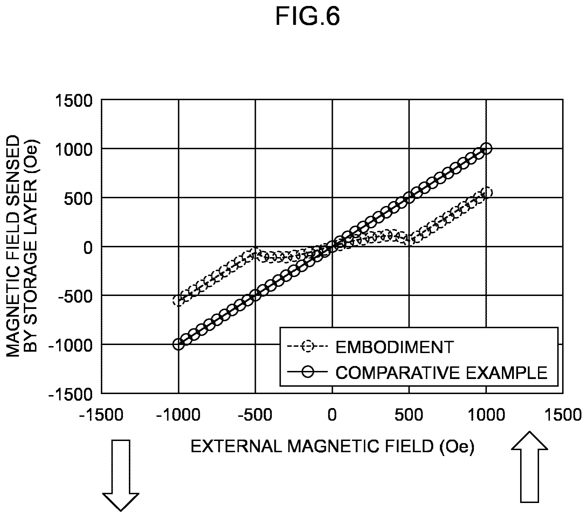

Next, simulation results of the MTJ element 100 of the embodiment will be described with reference to FIGS. 5 and 6. FIGS. 5 and 6 are explanatory diagrams for explaining simulation results of the MTJ element 100 of the embodiment.

Simulation of the magnetic field strength was performed that is sensed by the storage layer 106 when an external magnetic field 500 of ± 1000 (oersted (Oe)) was applied to the MTJ element 100 of the embodiment illustrated in FIG. 3 having physical properties (film thickness, diameter, and magnetic properties of each layer) illustrated in FIG. 5. The results are illustrated in FIG. 6. In FIG. 6, the external magnetic field 500 having a positive sign has a magnetic moment directed from the bottom to the top in FIG. 3, and the external magnetic field 500 having a negative sign has a magnetic moment from the top to the bottom in FIG. 3. Furthermore, the comparative example means an MTJ element including no layers (the separation layer 200, the magnetic layer 202, the antiparallel binding layer 204, and the magnetic layer 206) capable of suppressing the influence of the external magnetic field 500 of the embodiment.

According to FIG. 6, within the range where the external magnetic field 500 is ± 500 (Oe), the magnetic field strength sensed by the storage layer 106 is within 110 (Oe) at the maximum, and it has been found that the influence of the external magnetic field 500 on the storage layer 106 is suppressed as compared with the comparative example. In addition, it was found that even in a case where the external magnetic field 500 exceeding ± 500 (Oe) was applied, the magnetic field strength sensed by the storage layer 106 was relatively suppressed as compared with the comparative example.

As described above, in the present embodiment, the MTJ element 100 has, for example, a structure in which the separation layer 200, the magnetic layer 202, the antiparallel binding layer 204, and the magnetic layer 206 are sequentially stacked on the storage layer 106. In the present embodiment, due to such a configuration, the influence of the magnetic moment of the external magnetic field 500 is suppressed in the storage layer 106 when the external magnetic field 500 is applied.

Furthermore, according to the embodiment, since the layer for suppressing the influence of the external magnetic field 500 is included in the MTJ element 100, the layer for suppressing the influence of the external magnetic field 500 can be simultaneously formed at the time of manufacturing the MTJ element 100, and thus an increase in the manufacturing cost of the MRAM can be suppressed. In addition, in the present embodiment, the MRAM can be downsized as compared with a magnetic shield that covers the entire chip. Moreover, since the present embodiment does not cover the entire chip with a magnetic shield, the present embodiment can also be applied to a stacked structure with a chip of an image sensor in which the light-receiving surface cannot be covered.

That is, according to the embodiment, it is possible to suppress an increase in the manufacturing cost or the volume of the MRAM while effectively suppressing an influence from an external magnetic field.

### <2.4 First Modification>

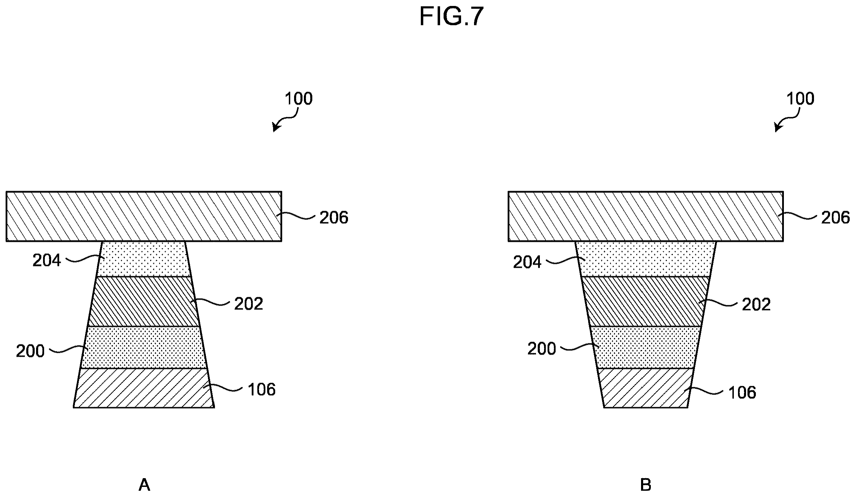

Next, the configuration of an MTJ element 100 according to a first modification of the present embodiment will be described with reference to FIG. 7. FIG. 7 is a cross-sectional view illustrating the MTJ element 100 according to the first modification of the embodiment.

In the present embodiment, the storage layer 106, the separation layer 200, the magnetic layer 202, and the antiparallel binding layer 204 are not limited to have the same area and may have different areas. For example, as illustrated in A of FIG. 7, the areas of cross sections of the storage layer 106, the separation layer 200, the magnetic layer 202, and the antiparallel binding layer 204 taken along a plane perpendicular to the stacking direction of the stacked structure may decrease in descending order from the storage layer 106 to the antiparallel binding layer 204.

Furthermore, for example, as illustrated in B of FIG. 7, the areas of cross sections of the storage layer 106, the separation layer 200, the magnetic layer 202, and the antiparallel binding layer 204 taken along a plane perpendicular to the stacking direction of the stacked structure may increase in ascending order from the storage layer 106 to the antiparallel binding layer 204.

That is, in the present modification, the MTJ element 100 may have a tapered stacked structure.

### <2.5 Second Modification>

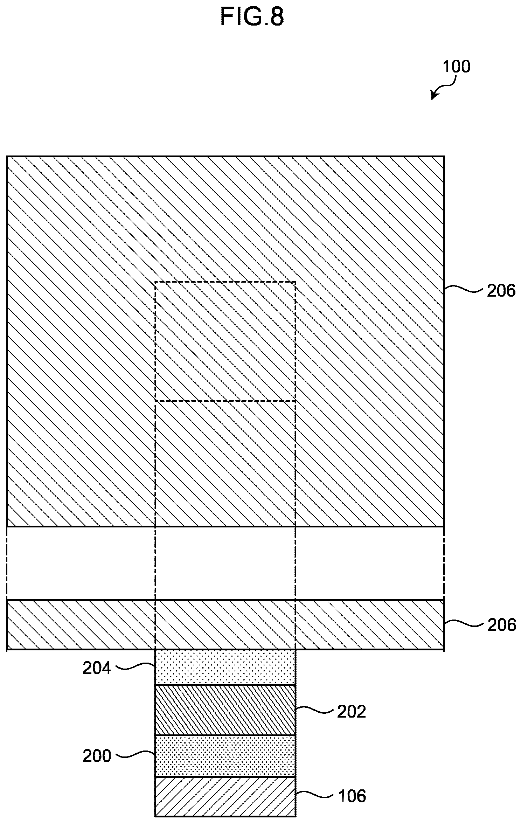

Next, the configuration of an MTJ element 100 according to a second modification of the present embodiment will be described with reference to FIG. 8. FIG. 8 is a cross-sectional view and a plane view illustrating the MTJ element 100 according to the second modification of the embodiment.

In the present embodiment, the storage layer 106, the separation layer 200, the magnetic layer 202, the antiparallel binding layer 204, and the magnetic layer 206 are not limited to have a substantially circular shape in a cross section taken along a plane perpendicular to the stacking direction of the stacked structure and may have a substantially rectangular shape. Here, the substantially rectangular shape includes a rectangle and a shape that can be approximated to a rectangle, such as a shape in which four corners of a rectangle are rounded.

For example, as illustrated in FIG. 8, the storage layer 106, the separation layer 200, the magnetic layer 202, the antiparallel binding layer 204, and the magnetic layer 206 have a substantially rectangular shape in a cross section taken along a plane perpendicular to the stacking direction of the stacked structure.

Furthermore, in the present embodiment, in a cross section taken along a plane perpendicular to the stacking direction of the stacked structure, the storage layer 106, the separation layer 200, the magnetic layer 202, and the antiparallel binding layer 204 may have a substantially circular shape, whereas the magnetic layer 206 may have a substantially rectangular shape. Details will be described later.

### <<3. Second Embodiment>>

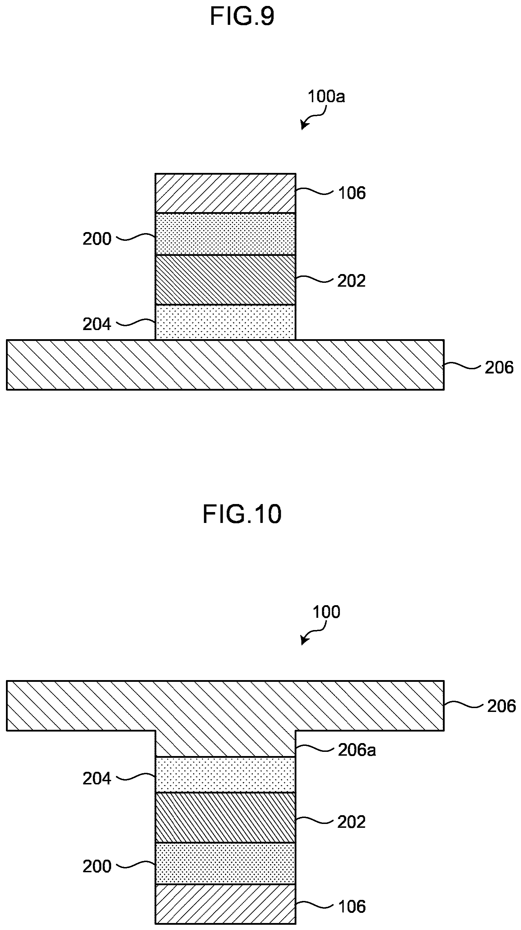

Next, the configuration of an MTJ element 100a according to a second embodiment of the disclosure will be described with reference to FIG. 9. FIG. 9 is a cross-sectional view illustrating an example of the MTJ element 100a according to the embodiment.

In an embodiment of the disclosure, the MTJ element 100 is only required to have a structure in which the separation layer 200, the magnetic layer (first magnetic layer) 202, the antiparallel binding layer 204, and the magnetic layer (second magnetic layer) 206 are sequentially stacked. That is, in an embodiment of the disclosure, the MTJ element 100 is not limited to have a stacked structure in which the separation layer 200 is provided on the storage layer 106, the magnetic layer 202 is provided on the separation layer 200, the antiparallel binding layer 204 is provided on the magnetic layer 202, and the magnetic layer 206 is provided on the antiparallel binding layer 204 and may be stacked in the reverse order.

Specifically, in the MTJ element 100a according to the second embodiment of the disclosure, as illustrated in FIG. 9, an antiparallel binding layer 204 is provided on a magnetic layer 206, a magnetic layer 202 is provided on the antiparallel binding layer 204, a separation layer 200 is provided on the magnetic layer 202, and a storage layer 106 is provided on the separation layer 200.

In addition, also in the present embodiment, in order to suppress the influence of the magnetic layer 206 from directly affecting the storage layer 106, the area of the magnetic layer 206 is preferably larger than that of the magnetic layer 202 in a cross section taken along a plane perpendicular to the stacking direction of the stacked structure.

Note that, in FIG. 9, only the storage layer 106 is illustrated to facilitate understanding, but the storage layer 106 in FIG. 9 has a stacked structure in which the storage layer 106, the nonmagnetic layer 104, and the fixed layer 102 are sequentially stacked from the lower side of FIG. 9.

Furthermore, in the present embodiment, the antiparallel binding layer 204, the magnetic layer 202, the separation layer 200, and the storage layer 106 are not limited to have the same area and may have different areas. For example, the areas of cross sections of the antiparallel binding layer 204, the magnetic layer 202, the separation layer 200, and the storage layer 106 taken along a plane perpendicular to the stacking direction of the stacked structure may decrease in descending order from the antiparallel binding layer 204 to the storage layer 106. Alternatively, also in the present embodiment, the areas of the cross sections of the antiparallel binding layer 204, the magnetic layer 202, the separation layer 200, and the storage layer 106 taken along a plane perpendicular to the stacking direction of the stacked structure may increase in ascending order from the antiparallel binding layer 204 to the storage layer 106.

As described above, also in the present embodiment, similarly to the first embodiment, it is possible to suppress an increase in the manufacturing cost or the volume of the MRAM while effectively suppressing an influence from an external magnetic field.

### <<4. Third Embodiment>>

Next, the configuration of an MTJ element 100 according to a third embodiment of the disclosure will be described with reference to FIG. 10. FIG. 10 is a cross-sectional view illustrating an example of the MTJ element 100 according to the embodiment.

In the present embodiment, as illustrated in FIG. 10, a magnetic layer 206 may have a protruding portion 206a protruding downward in the stacking direction of the stacked structure, and the protruding portion 206a may be in contact with the antiparallel binding layer 204.

Furthermore, in a case where the MTJ element 100 is stacked in the stacking order as in the second embodiment, the magnetic layer 206 may have a protruding portion 206a protruding upward in the stacking direction of the stacked structure, and the protruding portion 206a may be in contact with the antiparallel binding layer 204.

In the present embodiment, since the magnetic layer 206 has the protruding portion 206a in contact with the antiparallel binding layer 204, an end of the magnetic layer 206 can be disposed farther from the storage layer 106. As a result, also in the present embodiment, the leakage magnetism from the magnetic layer 206 can be suppressed from reaching the storage layer 106, and the influence from the magnetic layer 202 can be efficiently exerted on the storage layer 106.

As described above, also in the present embodiment, similarly to the first embodiment, it is possible to suppress an increase in the manufacturing cost or the volume of the MRAM while effectively suppressing an influence from an external magnetic field.

### <<5. Fourth Embodiment>>

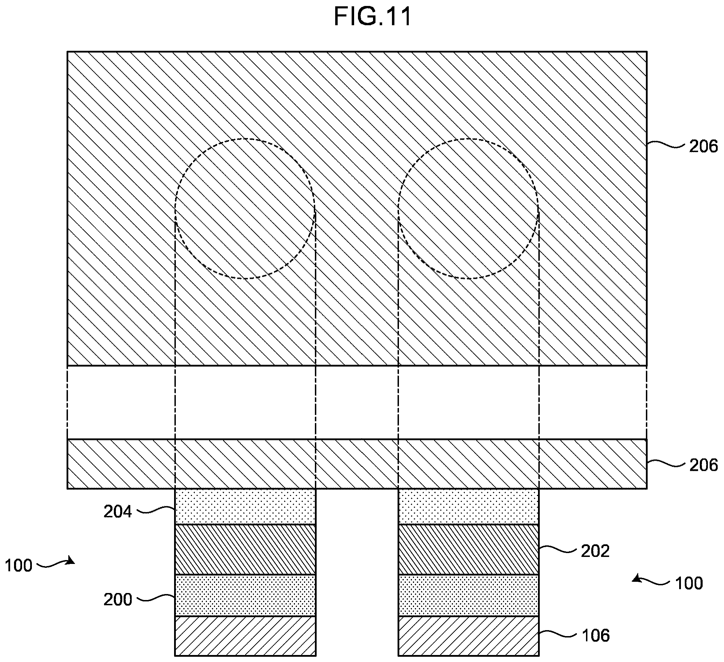

Next, the configuration of an MTJ element 100 according to a fourth embodiment of the disclosure will be described with reference to FIG. 11. FIG. 11 is a cross-sectional view and a plane view illustrating an example of the MTJ element 100 according to the embodiment.

In an embodiment of the disclosure, a plurality of MTJ elements 100 may share an upper electrode (not illustrated) with one magnetic layer 206. For example, as illustrated in FIG. 11, magnetic layers 206 of a plurality of adjacent MTJ elements 100 may be connected to each other and provided as an integrated layer. Note that although two MTJ elements 100 are illustrated in FIG. 11, the present embodiment is not limited thereto, and it is only required that two or more MTJ elements 100 share one magnetic layer 206. Also in the present embodiment, the magnetic layer 206 may be formed of a material having conductivity to function as the upper electrode described above.

Furthermore, in the present embodiment, in a cross section taken along a plane perpendicular to the stacking direction of the stacked structure, the storage layer 106, the separation layer 200, the magnetic layer 202, and the antiparallel binding layer 204 may have a substantially circular shape, whereas the magnetic layer 206 may have a substantially rectangular shape.

Note that the present modification is not limited to arranging the plurality of MTJ elements 100 to be adjacent to each other as illustrated in FIG. 11, and the plurality of MTJ elements 100 may be stacked in the stacking direction of the MTJ element 100 itself.

As described above, also in the present embodiment, similarly to the first embodiment, it is possible to suppress an increase in the manufacturing cost or the volume of the MRAM while effectively suppressing an influence from an external magnetic field.

### <<6. Fifth Embodiment>>

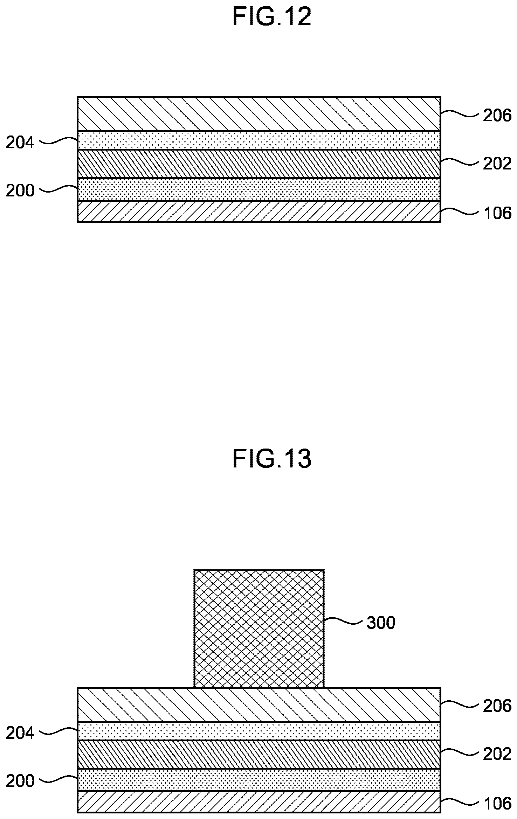

Next, a manufacturing method of an MTJ element 100 according to a fifth embodiment of the disclosure will be described with reference to FIGS. 12 to 17. FIGS. 12 to 17 are cross-sectional views illustrating the manufacturing method of the MTJ element 100 of the embodiment.

First, as illustrated in FIG. 12, a storage layer 106, a separation layer 200, a magnetic layer 202, an antiparallel binding layer 204, and a magnetic layer 206 are sequentially formed. Next, as illustrated in FIG. 13, a mask 300 patterned to correspond to the MTJ element 100 is formed on the magnetic layer 206.

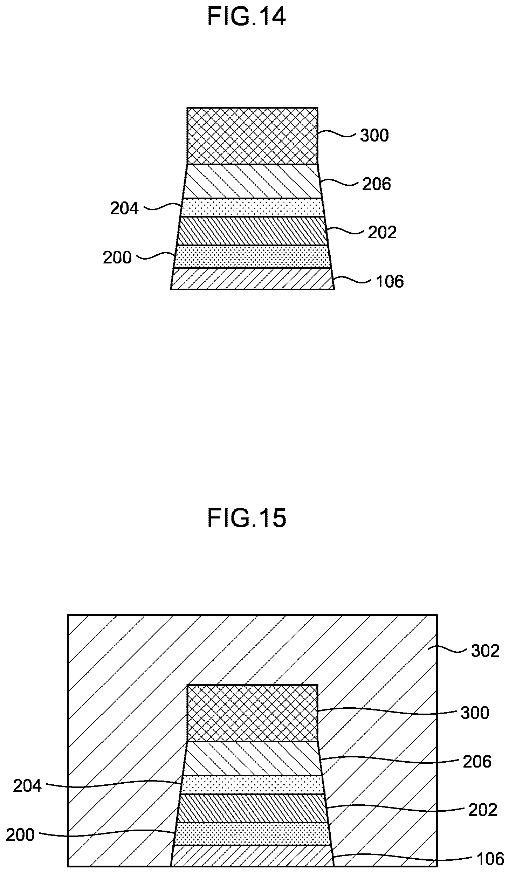

Next, as illustrated in FIG. 14, the stacked layers of the storage layer 106, the separation layer 200, the magnetic layer 202, the antiparallel binding layer 204, and the magnetic layer 206 are etched using ion milling or the like in accordance with the pattern of the mask 300. Furthermore, as illustrated in FIG. 15, an insulating film 302 is formed in such a manner as to cover the stacked layers of the storage layer 106, the separation layer 200, the magnetic layer 202, the antiparallel binding layer 204, the magnetic layer 206, and the mask 300 and to fill spaces between stack layers.

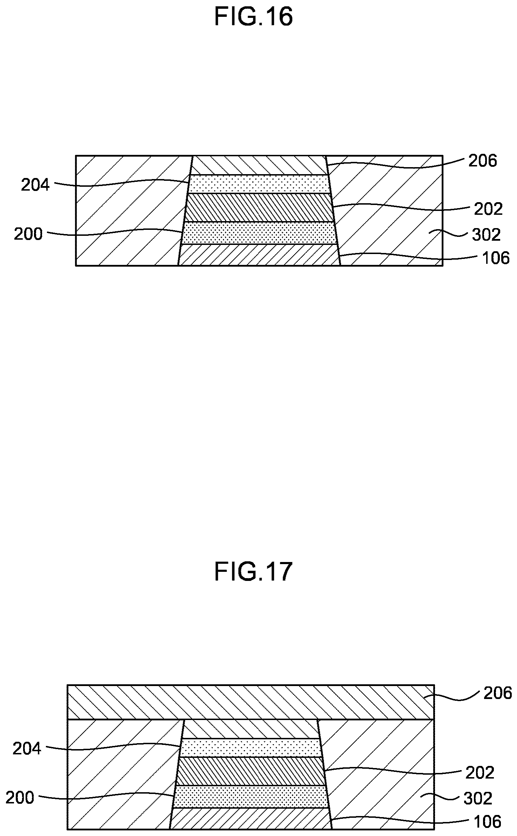

Next, as illustrated in FIG. 16, the mask 300 is removed, and planarization is performed using chemical mechanical polishing (CMP) in such a manner as to expose the top surface of the magnetic layer 206. Furthermore, as illustrated in FIG. 17, a magnetic layer 206 is further formed on the magnetic layer 206.

As described above, the MTJ element 100 according to the embodiment can be manufactured by using a method, a device, and conditions used for manufacturing a general semiconductor device.

Note that examples of the above-described method include a physical vapor deposition (PVD) method, a chemical vapor deposition (CVD) method, an atomic layer deposition (ALD) method, and the like. Examples of the PVD method include a vacuum vapor deposition method, an electron beam (EB) vapor deposition method, various sputtering methods (magnetron sputtering method, radio frequency (RF)-direct current (DC) coupled bias sputtering method, electron cyclotron resonance (ECR) sputtering method, counter target sputtering method, radio frequency sputtering method, and the like), an ion plating method, a laser ablation method, a molecular beam epitaxy (MBE) method, and a laser transfer method. Examples of the CVD method include a plasma CVD method, a thermal CVD method, an organic metal (MO) CVD method, and a photo-CVD method. Furthermore, examples of other methods include: an electroplating method, an electroless plating method, or a spin coating method; a dipping method; a cast method; a micro-contact printing; a drop cast method; various printing methods such as a screen printing method, an inkjet printing method, an offset printing method, a gravure printing method, and a flexographic printing method; a stamping method; a spray method; and various coating methods such as an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit orifice coater method, and a calendar coater method. Furthermore, examples of the patterning method include chemical etching such as shadow masking, laser transfer, or photolithography and physical etching using ultraviolet rays, laser, or the like. In addition, examples of the planarization technology include a CMP method, a laser planarization method, and a reflow method.

### <<7. Sixth Embodiment>>

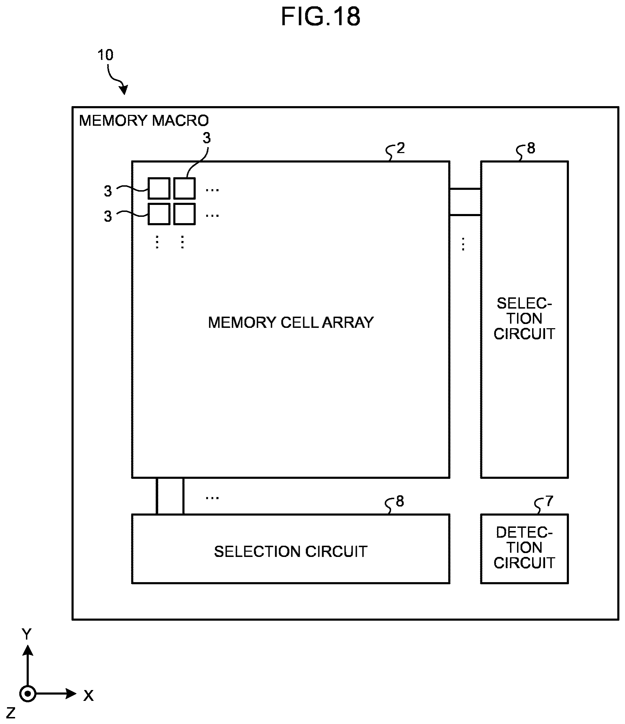

FIG. 18 is an explanatory diagram illustrating an exemplary schematic configuration of a storage device 10 according to a sixth embodiment of the disclosure. As illustrated in FIG. 18, the storage device 10 includes a memory cell array 2, a detection circuit 7, and a selection circuit 8.

The memory cell array 2 includes a plurality of memory cells 3. The plurality of memory cells 3 are two-dimensionally arranged in an array shape in the X-axis direction and the Y-axis direction. One memory cell 3 includes one MTJ element 100. In this sense, the memory cell array 2 can be rephrased as a memory element array including a plurality of MTJ elements 100.

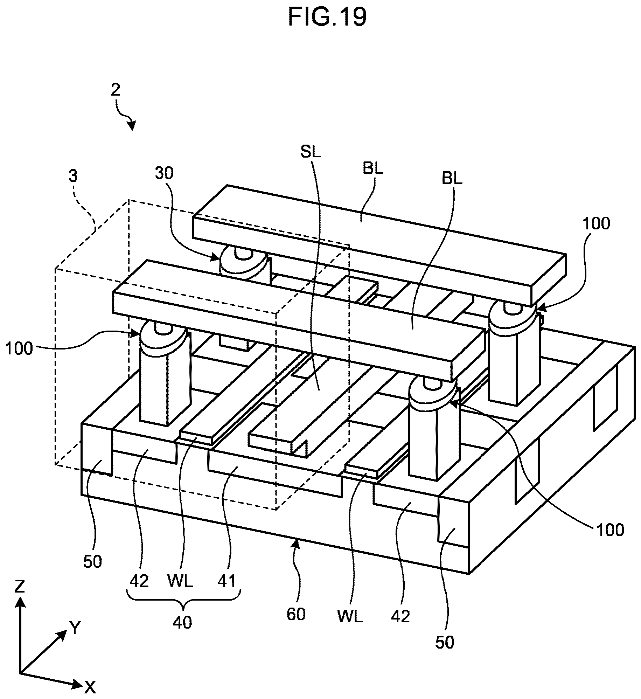

FIG. 19 is a diagram illustrating an exemplary schematic configuration of the memory cell array 2 according to the sixth embodiment of the disclosure. The memory cell array 2 includes a semiconductor substrate 60 and wiring in addition to the MTJ elements 100. Examples of the wiring include bit lines BL, word lines WL, and sensing lines SL. The semiconductor substrate 60 is, for example, a semiconductor substrate such as a silicon substrate.

There are a plurality of bit lines BL, a plurality of word lines WL, and a plurality of sensing lines SL, which extend from the memory cell array 2, namely, the plurality of MTJ elements 100 to the selection circuit 8 (see FIG. 18). The bit lines BL and the word lines WL are two types of address wires crossing each other. The sensing lines SL are provided corresponding to the bit lines BL. In this example, the bit lines BL extend in the X-axis direction, and the word lines WL extend in the Y-axis direction.

The MTJ elements 100 are arranged on the semiconductor substrate 60 (in this example, on the Z-axis positive direction side). Each MTJ element 100 is disposed in such a manner as to correspond to (for example, in the vicinity of) an intersection of a bit line BL and a word line WL. One terminal of an MTJ element 100 is connected to a bit line BL. For example, an upper electrode (not illustrated) of the MTJ element 100 is electrically connected to the bit line BL. The other terminal of the MTJ element 100 is connected to a selection transistor 40 described later. For example, a lower electrode (not illustrated) of the MTJ element 100 is connected to a selection transistor 40.

Furthermore, the semiconductor substrate 60 includes a plurality of selection transistors 40 and an element isolation region 50. The element isolation region 50 is an electrically isolated region. The selection transistor 40 is formed in a region isolated by the element isolation region 50. Each of the plurality of selection transistors 40 corresponds to, for example, one MTJ element 100 and is provided in such a manner as to select the MTJ element 100.

As indicated by a broken line in FIG. 19, one memory cell 3 includes a corresponding MTJ element 100 and a selection transistor 40. FIG. 19 schematically illustrates portions corresponding to four memory cells 3 among the plurality of memory cells 3 included in the memory cell array 2. In the one memory cell 3, the MTJ element 100 and the selection transistor 40 are connected between corresponding bit line BL and sensing line SL.

The selection transistor 40 illustrated in the example is a field effect transistor (FET) and includes a source region 41, a drain region 42, and a gate region. The gate electrode provided for the gate region is connected to the word line WL. In the example illustrated in FIG. 19, the word line WL includes the gate electrode. A sensing line SL is connected to the source region 41. The other terminal of the MTJ element 100 is connected to the drain region 42. Note that, in this example, the source region 41 is formed in a shared manner with a source region 41 of an adjacent selection transistor 40.

The MTJ element 100 is connected between the drain region 42 of the selection transistor 40 and the bit line BL in the Z-axis direction. The connection is established via, for example, a contact layer (via or the like).

The bit line BL, the word line WL, and the sensing line SL are connected to the selection circuit 8 (see FIG. 18) in such a manner that applying a voltage to the MTJ element 100 allows a desired current to flow therebetween. At the time of writing information, a voltage for conducting a current to an MTJ element 100 is applied via a bit line BL and a sensing line SL corresponding to a desired memory cell. A voltage is applied to the word line WL corresponding to the desired memory cell, namely, the gate electrode of the selection transistor 40, thereby turning on the selection transistor 40 (conductive state), whereby a current flows through the MTJ element 100. The current flows through the MTJ element 100, and information is written (stored). Meanwhile, at the time of reading information, a voltage is applied to a word line WL corresponding to a desired memory cell, namely, the gate electrode of the selection transistor 40, and a current flowing between the bit line BL and the sensing line SL, namely, a current flowing through the MTJ element 100 is detected. The detection of the current means detection of the magnitude of the electric resistance, and information is read by this detection.

### <<8. Summary>>

As described above, according to the embodiment of the disclosure, it is possible to suppress an increase in the manufacturing cost or the volume of the MRAM while effectively suppressing an influence from an external magnetic field. Specifically, in the present embodiment, the MTJ element 100 has, for example, a structure in which the separation layer 200, the magnetic layer 202, the antiparallel binding layer 204, and the magnetic layer 206 are sequentially stacked on the storage layer 106. In the present embodiment, due to such a configuration, the influence of the magnetic moment of the external magnetic field 500 is suppressed in the storage layer 106 when the external magnetic field 500 is applied.

Furthermore, according to the embodiment, since the layer for suppressing the influence of the external magnetic field 500 is included in the MTJ element 100, the layer for suppressing the influence of the external magnetic field 500 can be simultaneously formed at the time of manufacturing the MTJ element 100, and thus an increase in the manufacturing cost of the MRAM can be suppressed. In addition, in the present embodiment, the MRAM can be downsized as compared with a magnetic shield that covers the entire chip. Moreover, since the present embodiment does not cover the entire chip with a magnetic shield, the present embodiment can also be applied to a stacked structure with a chip of an image sensor in which the light-receiving surface cannot be covered.

### <<9. Application Examples>>

### <9.1 Application Example to Camera>

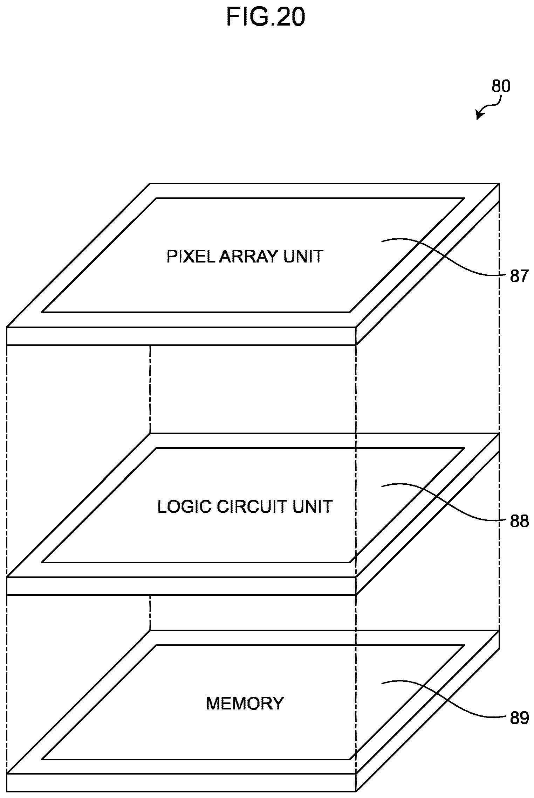

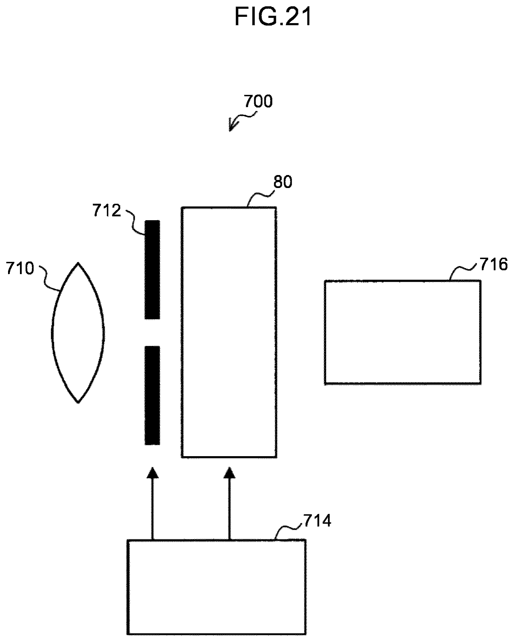

The technology according to the present disclosure (present technology) can be further applied to various products. For example, the technology according to the present disclosure may be applied to a camera or the like. Therefore, a configuration example of a camera 700 as an electronic device to which the present technology is applied will be described with reference to FIGS. 20 and 21. FIG. 20 is an explanatory diagram illustrating an example of a stacked structure of an imaging device 80 to which the technology according to the present disclosure can be applied. FIG. 21 is an explanatory diagram illustrating an example of a schematic functional configuration of a camera 700 to which the technology according to the present disclosure can be applied.

As illustrated in FIG. 20, the imaging device 80 to which the technology according to the present disclosure can be applied may include a stack of three chips 87, 88, and 89 or may include a stack of three wafers. Specifically, the chip 87 is mounted with a pixel array unit of an image sensor, the chip 88 is mounted with a logic circuit unit that controls the pixel array unit, and the chip 88 is mounted with a memory to which the technology according to the present disclosure can be applied. By applying the technology according to the present disclosure to such a stacked structure, it is possible to secure a light-receiving surface of the pixel array unit with the memory shielded from external magnetic fields.

As illustrated in FIG. 21, the camera 700 includes an imaging device 80, an optical lens 710, a shutter mechanism 712, a drive circuit unit 714, and a signal processing circuit unit 716. The optical lens 710 forms an image of image light (incident light) from a subject on a light-receiving surface of a pixel array unit of the imaging device 80. As a result, signal charges are accumulated in an imaging element of the imaging device 80 for a certain period of time. The shutter mechanism 712 opens and closes to control a light exposure period and a light shielding period for the imaging device 80. The drive circuit unit 714 supplies a drive signal for controlling a signal transfer operation of the imaging device 80, a shutter operation of the shutter mechanism 712, and others thereto. That is, the imaging device 80 performs signal transfer on the basis of the drive signal (timing signal) supplied from the drive circuit unit 714. The signal processing circuit unit 716 performs various types of signal processing. For example, the signal processing circuit unit 716 outputs a video signal subjected to the signal processing to, for example, a display unit (not illustrated).

The configuration example of the camera 700 has been described above. Each of the above components may be configured using a general-purpose member or may be configured by hardware specialized in the function of the component. Such a configuration can be modified as appropriate depending on the technical level at the time of implementation.

### <9.2 Application Example to Smartphone>

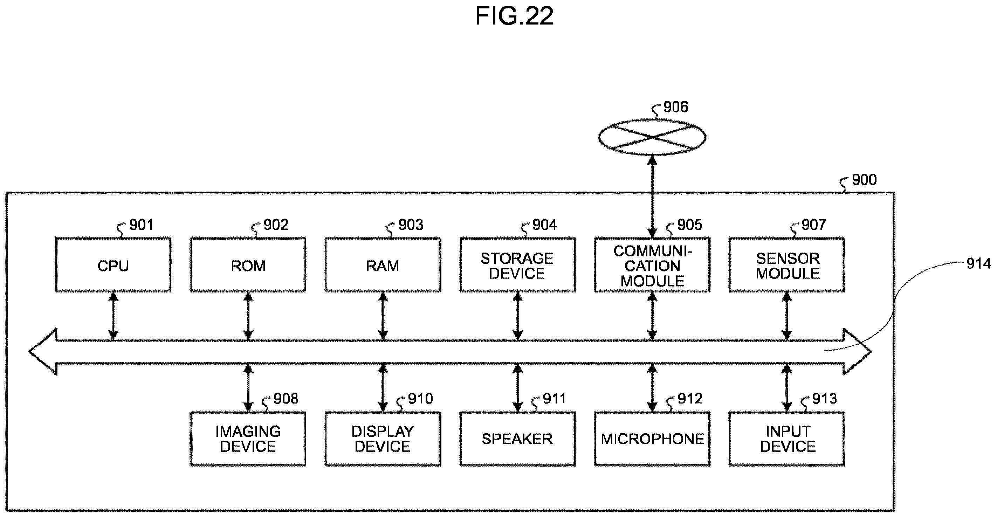

The technology according to the present disclosure may be applied to, for example, a smartphone or the like. Therefore, a configuration example of a smartphone 900 as an electronic device to which the present technology is applied will be described with reference to FIG. 22. FIG. 22 is a block diagram illustrating an example of a schematic functional configuration of the smartphone 900 to which the technology according to the present disclosure can be applied.

As illustrated in FIG. 22, the smartphone 900 includes a central processing unit (CPU) 901, a read only memory (ROM) 902, and a random access memory (RAM) 903. The smartphone 900 further includes a storage device 904, a communication module 905, and a sensor module 907. Furthermore, the smartphone 900 includes an imaging device 908, a display device 910, a speaker 911, a microphone 912, an input device 913, and a bus 914. Furthermore, the smartphone 900 may include a processing circuit such as a digital signal processor (DSP) instead of or in addition to the CPU 901.

The CPU 901 functions as an arithmetic processing device and a control device and controls the overall operation in the smartphone 900 or a part thereof in accordance with various programs recorded in the ROM 902, the RAM 903, the storage device 904, or the like. The ROM 902 stores programs, operation parameters, and others used by the CPU 901. The RAM 903 primarily stores programs used in execution by the CPU 901, parameters that vary as appropriate in the execution, and the like. The CPU 901, the ROM 902, and the RAM 903 are connected to each other by the bus 914. In addition, the storage device 904 is a device for data storage configured as an example of a storage unit of the smartphone 900. The technology according to the present disclosure can be applied to the storage device 904. The storage device 904 stores programs and various types of data executed by the CPU 901, various types of data acquired from the outside, and others.

The communication module 905 is a communication interface including, for example, a communication device for connecting to a communication network 906. The communication module 905 can be, for example, a communication card for wired or wireless local area network (LAN), Bluetooth (registered trademark), wireless USB (WUSB), or the like. Furthermore, the communication module 905 may be a router for optical communication, a router for asymmetric digital subscriber line (ADSL), a modem for various types of communication, or the like. The communication module 905 transmits and receives signals and the like to and from the Internet or other communication devices using a predetermined protocol such as Transmission Control Protocol (TCP) /Internet Protocol (IP). Furthermore, the communication network 906 connected to the communication module 905 is a network connected in a wired or wireless manner and is, for example, the Internet, a home LAN, infrared communication, satellite communication, or the like.

The sensor module 907 includes various sensors such as a motion sensor (for example, an acceleration sensor, a gyro sensor, a geomagnetic sensor, or the like), a biological information sensor (for example, a pulse sensor, a blood pressure sensor, a fingerprint sensor, and the like), or a position sensor (for example, a global navigation satellite system (GNSS) receiver or the like).

The imaging device 908 is provided on a surface of the smartphone 900 and can capture an image of an object or the like positioned behind or in front of the smartphone 900. Specifically, the technology according to the present disclosure can be applied to the imaging device 908 similarly to the camera 700 described above. Furthermore, the imaging device 908 can further include an optical system mechanism (not illustrated) including an imaging lens, a zoom lens, a focus lens, and the like and a drive system mechanism (not illustrated) that controls the operation of the optical system mechanism. Then, the imaging device 908 can collect incident light from an object as an optical image, photoelectrically convert the formed optical image for each imaging element, read a signal obtained by the conversion as an imaging signal, and perform image processing to acquire a captured image.

The display device 910 is provided on a surface of the smartphone 900 and can be a display device such as a liquid crystal display (LCD) or an organic electro luminescence (EL) display. The display device 910 can display an operation screen, a captured image acquired by the above-described imaging device 908, and others.

The speaker 911 can output, for example, a call voice, a voice accompanying the video content displayed by the display device 910 described above, and the like to a user.

The microphone 912 can collect, for example, a call voice of the user, a voice including a command to activate a function of the smartphone 900, and a voice in the surrounding environment of the smartphone 900.

The input device 913 is a device operated by the user, such as a button, a keyboard, a touch panel, or a mouse. The input device 913 includes an input control circuit that generates an input signal on the basis of information input by the user and outputs the input signal to the CPU 901. By operating the input device 913, the user can input various types of data to the smartphone 900 or instruct a processing operation.

The configuration example of the smartphone 900 has been described above. Each of the above components may be configured using a general-purpose member or may be configured by hardware specialized in the function of the component. Such a configuration can be modified as appropriate depending on the technical level at the time of implementation.

### <9.3 Application Example to Mobile Device Control System>

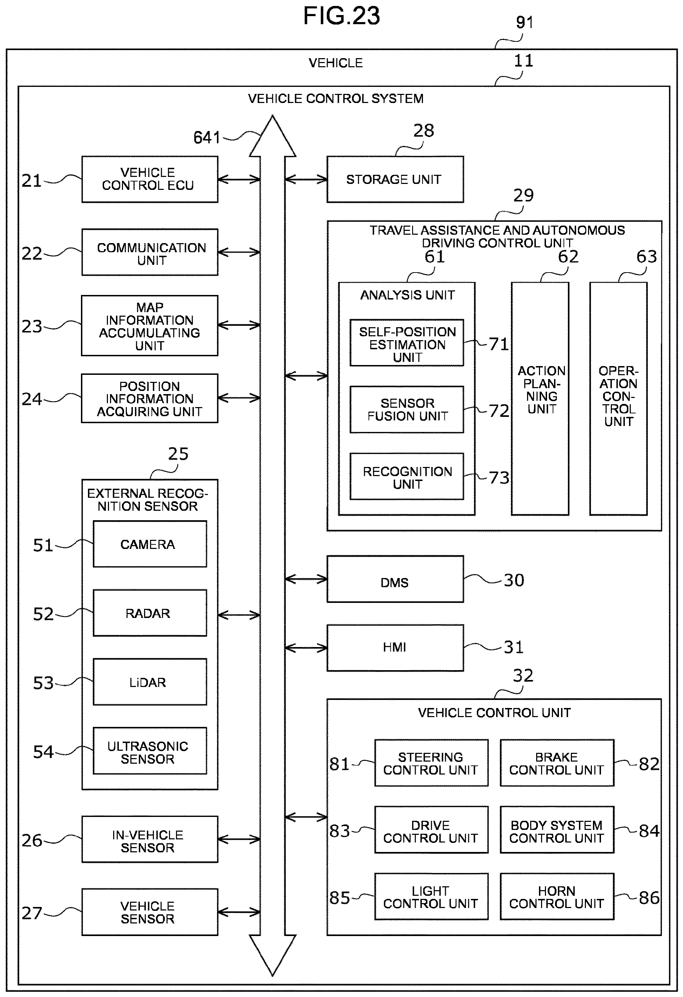

For example, the technology according to the present disclosure may be applied to a mobile device control system or the like. Therefore, an example of a mobile device control system to which the technology proposed in the present disclosure can be applied will be described with reference to FIG. 23. FIG. 23 is a block diagram illustrating a configuration example of a vehicle control system 11 as an example of the mobile device control system to which the technology of the present disclosure is applied.

The vehicle control system 11 is included in a vehicle 91 and performs processing related to travel assistance and autonomous driving of the vehicle 91.

The vehicle control system 11 includes a vehicle control electronic control unit (ECU) 21, a communication unit 22, a map information accumulating unit 23, a position information acquiring unit 24, an external recognition sensor 25, an in-vehicle sensor 26, a vehicle sensor 27, a storage unit 28, a travel assistance and autonomous driving control unit 29, a driver monitoring system (DMS) 30, a human-machine interface (HMI) 31, and a vehicle control unit 32.

The vehicle control ECU 21, the communication unit 22, the map information accumulating unit 23, the position information acquiring unit 24, the external recognition sensor 25, the in-vehicle sensor 26, the vehicle sensor 27, the storage unit 28, the travel assistance and autonomous driving control unit 29, the driver monitoring system (DMS) 30, the human-machine interface (HMI) 31, and the vehicle control unit 32 are communicably connected to each other via a communication network 641. The communication network 641 includes, for example, an in-vehicle communication network conforming to digital bilateral communication standards, such as a controller area network (CAN), a local interconnect network (LIN), a local area network (LAN), FlexRay (registered trademark), or Ethernet (registered trademark), a bus, or the like. The communication network 641 may be selectively used depending on the type of data to be transmitted. For example, a CAN may be applied to data related to vehicle control, and Ethernet may be applied to large-capacity data. Note that each unit of the vehicle control system 11 may be directly connected, not via the communication network 641, but by using wireless communication based on the premise of communication at a relatively short distance, such as near field communication (NFC) or Bluetooth (registered trademark).

Note that, hereinafter, in a case where each unit of the vehicle control system 11 performs communication via the communication network 641, description of the communication network 641 will be omitted. For example, in a case where the vehicle control ECU 21 and the communication unit 22 perform communication via the communication network 641, it is simply described that the vehicle control ECU 21 and the communication unit 22 perform communication.

The vehicle control ECU 21 includes, for example, various processors such as a central processing unit (CPU) or a micro processing unit (MPU). The vehicle control ECU 21 can control all or some of functions of the vehicle control system 11.

The communication unit 22 can communicate with various devices inside and outside the vehicle, other vehicles, servers, base stations, and the like and transmit and receive various types of data. At this point, the communication unit 22 may perform communication using a plurality of communication schemes.

Communication that the communication unit 22 can execute with the outside of the vehicle will be schematically described below. The communication unit 22 can communicate with a server or the like present on an external network (hereinafter, referred to as an external server) via a base station or an access point by a wireless communication scheme such as the 5th generation mobile communication system (5G), long term evolution (LTE), or dedicated short range communications (DSRC). The external network with which the communication unit 22 communicates is, for example, the Internet, a cloud network, a network unique to a company, or the like. The communication scheme performed by the communication unit 22 with the external network is not particularly limited as long as it is a wireless communication scheme capable of performing digital bidirectional communication at a communication speed higher than or equal to a predetermined speed and at a distance longer than or equal to a predetermined distance.

Furthermore, for example, the communication unit 22 can communicate with a terminal present in the vicinity of the host vehicle using the peer to peer (P2P) technology. Examples of the terminal present in the vicinity of the host vehicle include a terminal worn by a traveling body traveling at a relatively low speed such as a pedestrian or a bicycle, a terminal installed in a store or the like with a position fixed, or a machine type communication (MTC) terminal. Furthermore, the communication unit 22 can also perform V2X communication. The V2X communication refers to communication between the host vehicle and another party, such as vehicle to vehicle communication with another vehicle, vehicle to infrastructure communication with a roadside device or the like, vehicle to home communication with a house, and vehicle to pedestrian communication with a terminal or the like carried by a pedestrian.

The communication unit 22 can receive, for example, a program for updating software for controlling the operation of the vehicle control system 11 from the outside (Over-the-Air). The communication unit 22 can further receive map information, traffic information, information about the surroundings of the vehicle 91, and others from the outside. Furthermore, for example, the communication unit 22 can transmit information regarding the vehicle 91, information about the surroundings of the vehicle 91, and others to the outside. Examples of the information of the vehicle 91 transmitted to the outside by the communication unit 22 include data indicating the state of the vehicle 91, a recognition result by a recognition unit 73, and others. Furthermore, for example, the communication unit 22 can perform communication conforming to a vehicle emergency call system such as the eCall.

For example, the communication unit 22 can receive an electromagnetic wave transmitted by the vehicle information and communication system (VICS) (registered trademark) such as a radio wave beacon, an optical beacon, or FM multiplex broadcasting.

Communication that the communication unit 22 can execute with the inside of the vehicle will also be schematically described. The communication unit 22 can communicate with each device in the vehicle using, for example, wireless communication. The communication unit 22 can perform wireless communication with an in-vehicle device by a communication scheme capable of performing digital bidirectional communication at a communication speed higher than or equal to a predetermined speed by wireless communication, such as wireless LAN, Bluetooth (registered trademark), NFC, or wireless USB (WUSB). Without being limited to the above, the communication unit 22 can also communicate with each device in the vehicle using wired communication. For example, the communication unit 22 can communicate with each device in the vehicle by wired communication via a cable connected to a connection terminal (not illustrated). The communication unit 22 can communicate with each device in the vehicle by a communication scheme capable of performing digital bidirectional communication at a predetermined communication speed or higher by wired communication, such as the universal serial bus (USB), high-definition multimedia interface (HDMI) (registered trademark), or mobile high-definition link (MHL).

Here, a device in the vehicle refers to, for example, a device that is not connected to a communication network 941 in the vehicle. Those conceivable as the device in the vehicle include, for example, a mobile device or a wearable device carried by a passenger such as a driver, an information device brought into the vehicle and temporarily installed, or the like.

The map information accumulating unit 23 can accumulate one of or both a map acquired from the outside and a map created in the vehicle 91. For example, the map information accumulating unit 23 accumulates three-dimensional high-precision maps, a global map having lower accuracy than the high-precision maps but covering a wide area, and others.

The high-precision maps are, for example, dynamic maps, point cloud maps, vector maps, or others. The dynamic map is, for example, a map including four layers of dynamic information, semi-dynamic information, semi-static information, and static information and is provided to the vehicle 91 from an external server or the like. The point cloud map is a map including point clouds (point cloud data). The vector map is, for example, a map in which traffic information such as positions of lanes and traffic lights are associated with the point cloud map and adapted to an advanced driver assistance system (ADAS) or autonomous driving (AD).

The point cloud map and the vector map may be provided from, for example, an external server or the like or may be created in the vehicle 91 as a map for performing matching with a local map to be described later on the basis of a sensing result by a camera 51, a radar 52, a LiDAR (light detection and ranging or laser imaging detection and ranging) 53, or the like and accumulated in the map information accumulating unit 23. In addition, in a case where a high-precision map is provided from an external server or the like, for example, map data of several hundred meters square regarding a planned path on which the vehicle 91 is about to travel is acquired from an external server or the like in order to reduce the communication volume.

The position information acquiring unit 24 can receive global navigation satellite system (GNSS) signals from GNSS satellites and acquire position information of the vehicle 91. The acquired position information is supplied to the travel assistance and autonomous driving control unit 29. Note that the position information acquiring unit 24 is not limited to the method using the GNSS signals and may acquire the position information using, for example, a beacon.

The external recognition sensor 25 includes various sensors used for recognition of a situation outside the vehicle 91 and can supply sensor data from each sensor to each unit of the vehicle control system 11. The type and the number of sensors included in the external recognition sensor 25 are not particularly limited.

For example, the external recognition sensor 25 includes the camera 51, the radar 52, the LiDAR 53, and an ultrasonic sensor 54. Without being limited thereto, the external recognition sensor 25 may include one or more types of sensors of the camera 51, the radar 52, the LiDAR 53, and the ultrasonic sensor 54. The numbers of cameras 51, radars 52, LiDARs 53, and ultrasonic sensors 54 are not particularly limited as long as they can be practically installed in the vehicle 91. Furthermore, the types of sensors included in the external recognition sensor 25 are not limited to this example, and the external recognition sensor 25 may include other types of sensors. An example of the sensing region of each sensor included in the external recognition sensor 25 will be described later.

Note that the imaging method of the camera 51 is not particularly limited. For example, cameras of various imaging methods such as a time-of-flight (ToF) camera, a stereo camera, a monocular camera, and an infrared camera of an imaging method capable of ranging can be applied to the camera 51 as necessary. Moreover, the camera 51 may simply acquire a captured image regardless of ranging. Furthermore, the above-described imaging device 80 can be applied to the camera 51.

Furthermore, for example, the external recognition sensor 25 can include an environment sensor for detecting the environment for the vehicle 91. The environment sensor is a sensor for detecting an environment such as the weather, the climate, or the brightness and can include various sensors such as a raindrop sensor, a fog sensor, a sunshine sensor, a snow sensor, or an illuminance sensor.

Furthermore, for example, the external recognition sensor 25 includes a microphone used for detection of sound around the vehicle 91, a position of a sound source, and the like.

The in-vehicle sensor 26 includes various sensors for detecting information inside the vehicle and can supply sensor data from the sensors to respective units of the vehicle control system 11. The type and the number of various sensors included in the in-vehicle sensor 26 are not particularly limited as long as they can be practically installed in the vehicle 91.

For example, the in-vehicle sensor 26 can include one or more types of sensors of a camera, a radar, a seating sensor, a steering wheel sensor, a microphone, and a biological sensor. As the camera included in the in-vehicle sensor 26, for example, cameras of various imaging methods capable of ranging, such as a ToF camera, a stereo camera, a monocular camera, or an infrared camera, can be used. Without being limited to the above, the camera included in the in-vehicle sensor 26 may simply acquire a captured image regardless of ranging. The imaging device 80 including the embodiments of the disclosure can also be applied to the camera included in the in-vehicle sensor 26. The biological sensor included in the in-vehicle sensor 26 is included, for example, in a seat, a steering wheel, or the like and detects various types of biological information of a passenger such as the driver.

The vehicle sensor 27 includes various sensors for detecting the state of the vehicle 91 and can supply sensor data from the sensors to respective units of the vehicle control system 11. The type and the number of various sensors included in the vehicle sensor 27 are not particularly limited as long as they can be practically installed in the vehicle 91.

For example, the vehicle sensor 27 can include a speed sensor, an acceleration sensor, an angular velocity sensor (gyro sensor), and an inertial measurement unit (IMU) integrating these sensors. For example, the vehicle sensor 27 includes a steering angle sensor that detects the steering angle of the steering wheel, a yaw rate sensor, an accelerator sensor that detects an operation amount of the accelerator pedal, and a brake sensor that detects an operation amount of the brake pedal. For example, the vehicle sensor 27 includes a rotation sensor that detects the number of revolutions of the engine or the motor, an air pressure sensor that detects the air pressure of the tires, a slip rate sensor that detects the slip rate of the tires, and a wheel speed sensor that detects the rotation speed of the wheels. For example, the vehicle sensor 27 includes a battery sensor that detects the remaining amount and the temperature of the battery and an impact sensor that detects an external impact.

The storage unit 28 includes at least one of a nonvolatile storage medium or a volatile storage medium and can store data or a program. The technology of the present disclosure can be applied to the storage unit 28. The storage unit 28 stores various programs and data used by each unit of the vehicle control system 11. For example, the storage unit 28 includes an event data recorder (EDR) or a data storage system for automated driving (DSSAD) and stores information of the vehicle 91 before and after an event such as an accident or information acquired by the in-vehicle sensor 26.

The travel assistance and autonomous driving control unit 29 can control travel assistance and autonomous driving of the vehicle 91. For example, the travel assistance and autonomous driving control unit 29 includes an analysis unit 61, an action planning unit 62, and an operation control unit 63.

The analysis unit 61 can perform analysis processing of the situation of the vehicle 91 and the surroundings. The analysis unit 61 includes a self-position estimation unit 71, a sensor fusion unit 72, and the recognition unit 73.

The self-position estimation unit 71 can estimate the self-position of the vehicle 91 on the basis of the sensor data from the external recognition sensor 25 and the high-precision maps accumulated in the map information accumulating unit 23. For example, the self-position estimation unit 71 generates a local map on the basis of the sensor data from the external recognition sensor 25 and estimates the self-position of the vehicle 91 by matching the local map with the high-precision maps. The position of the vehicle 91 can be based on, for example, the center of the axle of the pair of rear wheels.

The local map is, for example, a three-dimensional high-precision map created using technology such as simultaneous localization and mapping (SLAM), an occupancy grid map, or the like. The three-dimensional high-precision map is, for example, the above-described point cloud map or the like. The occupancy grid map is a map in which a three-dimensional or two-dimensional space around the vehicle 91 is divided into grids of a predetermined size, and an occupancy state of an object is indicated for every grid. The occupancy state of the object is indicated by, for example, the presence or absence or the presence probability of the object. The local map is also used for detection processing and recognition processing of a situation outside the vehicle 91 by the recognition unit 73, for example.

Note that the self-position estimation unit 71 may estimate the self-position of the vehicle 91 on the basis of the position information acquired by the position information acquiring unit 24 and the sensor data from the vehicle sensor 27.

The sensor fusion unit 72 can perform sensor fusion processing of combining a plurality of different types of sensor data (for example, image data supplied from the camera 51 and sensor data supplied from the radar 52) to obtain new information. Those conceivable as methods for combining different types of sensor data are integration, fusion, association, and the like.

The recognition unit 73 can execute detection processing for detecting the situation outside the vehicle 91 and recognition processing for recognizing the situation outside the vehicle 91.

For example, the recognition unit 73 performs the detection processing and the recognition processing of the situation outside the vehicle 91 on the basis of information from the external recognition sensor 25, information from the self-position estimation unit 71, information from the sensor fusion unit 72, and others.

Specifically, for example, the recognition unit 73 performs the detection processing, the recognition processing, and others of an object around the vehicle 91. The detection processing of an object is, for example, processing of detecting the presence or absence, the size, the shape, the position, the motion, and the like of the object. The recognition processing of an object is, for example, processing of recognizing an attribute such as the type of the object or identifying a specific object. Note that the detection processing and the recognition processing are not necessarily clearly separated and may overlap with each other.

For example, the recognition unit 73 detects an object around the vehicle 91 by performing clustering of classifying point clouds based on sensor data by the radar 52, the LiDAR 53, or the like into groups of point clouds. As a result, the presence or absence, the size, the shape, and the position of the object around the vehicle 91 are detected.

For example, the recognition unit 73 detects the motion of the object around the vehicle 91 by performing tracking of following the motion of a group of point clouds classified by the clustering. As a result, the speed and the traveling direction (travel vector) of the object around the vehicle 91 are detected.

For example, the recognition unit 73 detects or recognizes a vehicle, a person, a bicycle, an obstacle, a structure, a road, a traffic light, a traffic sign, road marking, and the like on the basis of image data supplied from the camera 51. Furthermore, the recognition unit 73 may recognize the type of the object around the vehicle 91 by performing recognition processing such as semantic segmentation.

For example, the recognition unit 73 can perform recognition processing of traffic rules around the vehicle 91 on the basis of the maps accumulated in the map information accumulating unit 23, an estimation result of the self-position by the self-position estimation unit 71, and a recognition result of the object around the vehicle 91 by the recognition unit 73. Through this processing, the recognition unit 73 can recognize the position and the state of the traffic light, the content of the traffic sign and the road marking, the content of the traffic regulations, travelable lanes, and the like.

For example, the recognition unit 73 can perform the recognition processing of the environment around the vehicle 91. Those conceivable as the surrounding environment to be recognized by the recognition unit 73 include the weather, the temperature, the humidity, the brightness, the state of a road surface, and the like.

The action planning unit 62 creates an action plan for the vehicle 91. For example, the action planning unit 62 can create an action plan by performing processing of global path planning and path tracking.

Note that the global path planning is processing of planning a rough path from the start to the goal. This global path planning also includes processing of performing local path planning, referred to as path planning, which enables safe and smooth traveling in the vicinity of the vehicle 91 in consideration of the motion characteristics of the vehicle 91 on the planned path.

The path tracking is processing of planning an operation for safely and accurately traveling on the path planned by the global path planning within a planned time. For example, the action planning unit 62 can calculate a target speed and a target angular velocity of the vehicle 91 on the basis of the result of the path tracking processing.

The operation control unit 63 can control the operation of the vehicle 91 in order to implement the action plan created by the action planning unit 62.

For example, the operation control unit 63 controls a steering control unit 81, a brake control unit 82, and a drive control unit 83 included in the vehicle control unit 32, to be described later, to perform acceleration and deceleration control and direction control in such a manner that the vehicle 91 travels on the path calculated by the local path planning. For example, the operation control unit 63 performs cooperative control for the purpose of implementing the functions of the ADAS such as collision avoidance or impact mitigation, follow-up traveling, vehicle speed maintaining traveling, collision warning for the host vehicle, lane deviation warning for the host vehicle, and the like. The operation control unit 63 performs, for example, cooperative control for the purpose of autonomous driving or the like in which the vehicle travels autonomously without depending on the operation of the driver.

The DMS 30 can perform authentication processing of the driver, recognition processing of the state of the driver, and the like on the basis of sensor data from the in-vehicle sensor 26, input data input to the HMI 31 to be described later, and others. Those conceivable as the state of the driver to be recognized include, for example, the physical condition, the arousal level, the concentration level, the fatigue level, the line-of-sight direction, the drunkenness level, a driving operation, the posture, and the like.

Note that the DMS 30 may perform authentication processing of a passenger other than the driver and recognition processing of the state of the passenger. Furthermore, for example, the DMS 30 may perform recognition processing of the situation inside the vehicle on the basis of the sensor data from the in-vehicle sensor 26. Those conceivable as the situation inside the vehicle to be recognized include, for example, the temperature, the humidity, the brightness, the odor or the sent, and the like.

The HMI 31 can input various types of data, instructions, and the like and present various types of data to the driver and others.

Data input by the HMI 31 will be schematically described. The HMI 31 has an input device for a person to input data. The HMI 31 generates an input signal on the basis of data, an instruction, or the like input by the input device and supplies the input signal to each unit of the vehicle control system 11. The HMI 31 includes an operator such as a touch panel, a button, a switch, or a lever as the input device. Without being limited to the above, the HMI 31 may further include an input device capable of inputting information by a method other than manual operation such as by voice, a gesture, or others. Furthermore, the HMI 31 may use, for example, a remote control device using infrared rays or radio waves or an external connection device such as a mobile device or a wearable device supporting the operation of the vehicle control system 11 as the input device.

Presentation of data by the HMI 31 will be schematically described. The HMI 31 generates visual information, auditory information, and tactile information for the passengers or the outside of the vehicle. In addition, the HMI 31 performs output control for controlling output, the output content, the output timing, the output method, and others of each piece of information that is generated. The HMI 31 generates and outputs, as the visual information, information indicated by images or light such as an operation screen, state display of the vehicle 91, warning display, or a monitor image indicating the situation around the vehicle 91. Furthermore, the HMI 31 generates and outputs information indicated by sound such as a voice guidance, a warning sound, or a warning message as the auditory information. Furthermore, the HMI 31 generates and outputs, as the tactile information, information given to the tactile sense of the passenger by, for example, a force, vibrations, a motion, or the like.

As an output device with which the HMI 31 outputs the visual information, for example, a display device that presents the visual information by displaying an image thereon or a projector device that presents the visual information by projecting an image are applicable. Note that the display device may be a device that displays the visual information in the field of view of the passenger such as a head-up display, a transmissive display, or a wearable device having an augmented reality (AR) function other than a display device having a normal display. In addition, the HMI 31 can use display devices included in a navigation device, an instrument panel, a camera monitoring system (CMS), an electronic mirror, a lamp, or the like included in the vehicle 91 as an output device that outputs the visual information.

As an output device from which the HMI 31 outputs the auditory information, for example, an audio speaker, headphones, or earphones are applicable.

As an output device to which the HMI 31 outputs the tactile information, for example, a haptics element using haptic technology is applicable. The haptics element is provided, for example, at a portion with which a passenger of the vehicle 91 comes into contact, such as the steering wheel or a seat.

The vehicle control unit 32 can control each unit of the vehicle 91. The vehicle control unit 32 includes the steering control unit 81, a brake control unit 82, the drive control unit 83, a body system control unit 84, a light control unit 85, and a horn control unit 86.

The steering control unit 81 can detect and control the state of the steering system of the vehicle 91. The steering system includes, for example, a steering mechanism including a steering wheel and the like, an electric power steering, and the like. The steering control unit 81 includes, for example, a steering ECU that controls the steering system, an actuator that drives the steering system, and others.

The brake control unit 82 can detect and control the state of the brake system of the vehicle 91. The brake system includes, for example, a brake mechanism including a brake pedal and the like, an antilock brake system (ABS), a regenerative brake mechanism, and the like. The brake control unit 82 includes, for example, a brake ECU that controls the brake system, an actuator that drives the brake system, and the like.

The drive control unit 83 can detect and control the state of a drive system of the vehicle 91. The drive system includes, for example, a driving force generation device for generating a driving force such as an accelerator pedal, an internal combustion engine, and a driving motor, a driving force transmission mechanism for transmitting the driving force to the wheels, and others. The drive control unit 83 includes, for example, a drive ECU that controls the drive system, actuators that drive the drive system, and others.

The body system control unit 84 can detect and control the state of a body system of the vehicle 91. The body system includes, for example, a keyless entry system, a smart key system, a power window device, a power seat, an air conditioner, an airbag, a seat belt, a shift lever, and others. The body system control unit 84 includes, for example, a body system ECU that controls the body system, actuators that drive the body system, and others.

The light control unit 85 can detect and control states of various lights of the vehicle 91. Those conceivable as the lights to be controlled include, for example, a headlight, a backlight, a fog light, a turn signal, a brake light, projection, display on a bumper, and the like. The light control unit 85 includes a light ECU that controls the lights, actuators that drive the lights, and the like.

The horn control unit 86 can detect and control the state of a car horn of the vehicle 91. The horn control unit 86 includes, for example, a horn ECU that controls the car horn, an actuator that drives the car horn, and the like.

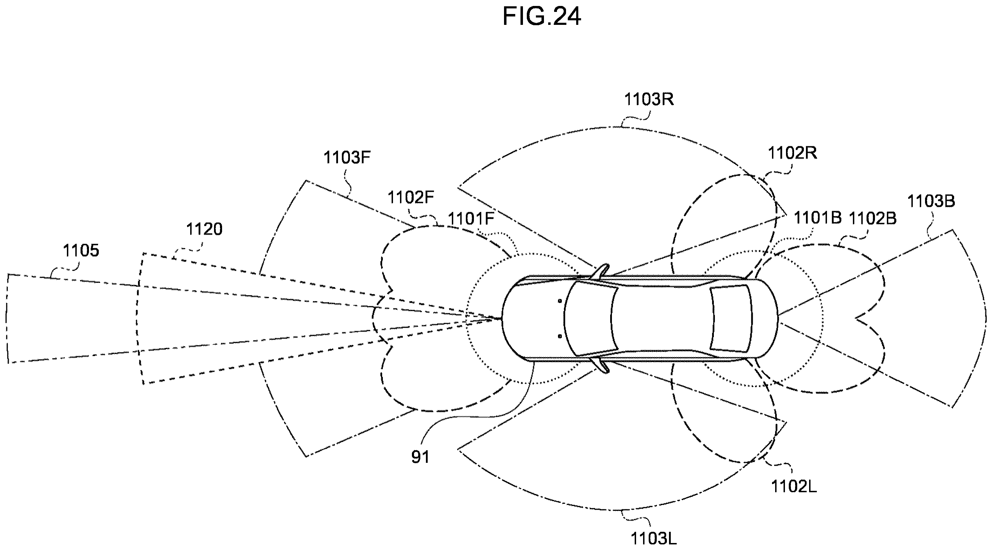

FIG. 24 is a diagram illustrating an example of sensing regions by the camera 51, the radar 52, the LiDAR 53, the ultrasonic sensor 54, or others of the external recognition sensor 25 in FIG. 23. Note that FIG. 24 schematically illustrates the vehicle 91 as viewed from above, in which the left end side is the front end (front) side of the vehicle 91, and the right end side is the rear end (rear) side of the vehicle 91.

A sensing region 1101F and a sensing region 1101B indicate examples of sensing regions of ultrasonic sensors 54. The sensing region 1101F covers the periphery of the front end of the vehicle 91 by a plurality of ultrasonic sensors 54. The sensing region 1101B covers the periphery of the rear end of the vehicle 91 by a plurality of ultrasonic sensors 54.

Sensing results in the sensing region 1101F and the sensing region 1101B are used for, for example, parking assistance or the like of the vehicle 91.

A sensing region 1102F or a sensing region 1102B indicates an example of a sensing region of the radar 52 for a short distance or a middle distance. The sensing region 1102F covers up to a position farther than the sensing region 1101F ahead of the vehicle 91. The sensing region 1102B covers up to a position farther than the sensing region 1101B behind the vehicle 91. A sensing region 1102L covers the rear periphery of the left side face of the vehicle 91. A sensing region 1102R covers the rear periphery of the right side face of the vehicle 91.

A sensing result in the sensing region 1102F is used for, for example, detecting a vehicle, a pedestrian, or the like present ahead of the vehicle 91. A sensing result in the sensing region 1102B is used for, for example, a collision prevention function or the like behind the vehicle 91. Sensing results in the sensing region 1102L and the sensing region 1102R are used for, for example, detecting an object in a blind spot on the sides of the vehicle 91.

A sensing region 1103F or a sensing region 1103B indicates an example of a sensing region by the camera 51. The sensing region 1103F covers up to a position farther than the sensing region 1102F ahead of the vehicle 91. The sensing region 1103B covers up to a position farther than the sensing region 1102B behind the vehicle 91. A sensing region 1103L covers the periphery of the left side face of the vehicle 91. A sensing region 1103R covers the periphery of the right side face of the vehicle 91.

A sensing result in the sensing region 1103F can be used for, for example, recognition of a traffic light or a traffic sign, a lane deviation prevention assist system, and an automatic headlight control system. A sensing result in the sensing region 1103B can be used for, for example, parking assistance and a surround view system. Sensing results in the sensing region 1103L and the sensing region 1103R can be used for the surround view system, for example.

A sensing region 1120 indicates an example of a sensing region of the LiDAR 53. The sensing region 1120 covers up to a position farther than the sensing region 1103F ahead of the vehicle 91. Meanwhile, the sensing region 1120 has a narrower area in the left-right direction than that of the sensing region 1103F.

A sensing result in the sensing region 1120 is used for, for example, detecting an object such as a vehicle in the surroundings.

A sensing region 1105 indicates an example of a sensing region of the radar 52 for a long distance. The sensing region 1105 covers up to a position farther than the sensing region 1120 ahead of the vehicle 91. Meanwhile, the sensing region 1105 has a narrower area in the left-right direction than that of the sensing region 1120.

A sensing result in the sensing region 1105 is used for, for example, adaptive cruise control (ACC), emergency braking, collision avoidance, and the like.

Note that the sensing regions of the sensors of the camera 51, the radar 52, the LiDAR 53, and the ultrasonic sensor 54 included in the external recognition sensor 25 may have various configurations other than those in FIG. 24. Specifically, the ultrasonic sensors 54 may also perform sensing on the sides of the vehicle 91, or the LiDAR 53 may perform sensing behind the vehicle 91. In addition, the installation positions of the sensors are not limited to the examples described above. Furthermore, the number of sensors may be one or plural.

### <<10. Supplements>>

Although the preferred embodiments of the disclosure have been described in detail by referring to the accompanying drawings, the technical scope of the disclosure is not limited to such examples. It is obvious that a person having ordinary knowledge in the technical field of the present disclosure can conceive various modifications or variations within the scope of the technical idea described in the claims, and it is naturally understood that these also belong to the technical scope of the present disclosure.

Incidentally, the effects described in the present specification are merely illustrative or exemplary and are not limiting. That is, the technology according to the present disclosure can achieve other effects that are obvious to those skilled in the art from the description of the present specification together with or in place of the above effects.

Note that the present technology can also have the following configurations.
(1) A storage element comprising: a stacked structure in which a storage layer whose magnetization direction can be reversed, a separation layer, a first magnetic layer, an antiparallel binding layer, and a second magnetic layer are stacked in this order.
(2) The storage element according to (1), wherein an area of the second magnetic layer is wider than an area of the first magnetic layer in a cross section taken along a plane perpendicular to a stacking direction of the stacked structure.
(3) The storage element according to (1) or (2), wherein the storage layer, the separation layer, the first magnetic layer, and the antiparallel binding layer have a substantially circular or substantially rectangular shape in a cross section taken along a plane perpendicular to a stacking direction of the stacked structure.
(4) The storage element according to (3), wherein the second magnetic layer has a substantially circular or substantially rectangular shape in a cross section taken along a plane perpendicular to the stacking direction of the stacked structure.
(5) The storage element according to any one of (1) to (4),
   wherein in the stacked structure,
   the separation layer is provided on the storage layer,
   the first magnetic layer is provided on the separation layer,
   the antiparallel binding layer is provided on the first magnetic layer, and
   the second magnetic layer is provided on the antiparallel binding layer.
(6) The storage element according to (5),
   wherein the second magnetic layer has a protruding portion protruding downward in the stacking direction of the stacked structure, and
   the protruding portion is in contact with the antiparallel binding layer.
(7) The storage element according to (5), wherein areas of cross sections of the storage layer, the separation layer, the first magnetic layer, and the antiparallel binding layer taken along a plane perpendicular to the stacking direction of the stacked structure decrease in descending order from the storage layer to the antiparallel binding layer.
(8) The storage element according to any one of (1) to (4),
   wherein in the stacked structure,
   the antiparallel binding layer is provided on the second magnetic layer,
   the first magnetic layer is provided on the antiparallel binding layer,
   the separation layer is provided on the first magnetic layer, and
   the storage layer is provided on the separation layer.
(9) The storage element according to (8),
   wherein the second magnetic layer has a protruding portion protruding upward in the stacking direction of the stacked structure, and
   the protruding portion is in contact with the antiparallel binding layer.
(10) The storage element according to (8), wherein areas of cross sections of the antiparallel binding layer, the first magnetic layer, the separation layer, and the storage layer taken along a plane perpendicular to the stacking direction of the stacked structure decrease in descending order from the storage layer to the antiparallel binding layer.
(11) The storage element according to any one of (1) to (10), wherein the first and second magnetic layers contain at least one ferromagnetic material selected from the group consisting of CoPt, CoNi, CoFeB, CoFe, and NiFe.
(12) The storage element according to any one of (1) to (11), wherein the first and second magnetic layers have a film thickness of greater than or equal to 1 nm and less than 10 nm.
(13) The storage element according to any one of (1) to (12), wherein the antiparallel binding layer contains at least one element selected from the group consisting of Ru, Ir, and Os.
(14) The storage element according to any one of (1) to (13), wherein the antiparallel binding layer has a film thickness of greater than or equal to 3 angstroms and less than 15 angstroms.
(15) The storage element according to any one of (1) to (14), wherein the separation layer contains at least one selected from the group consisting of Cu, Ta, TaN, Ru, Zr, Ir, Cr, W, Mo, Pt, Pd, Al, Si, and CoFeB.
(16) The storage element according to any one of (1) to (15), wherein the separation layer has a film thickness of greater than or equal to 1 nm and less than 10 nm.
(17) The storage element according to any one of (1) to (16),
   wherein the stacked structure further includes:
   a reference layer provided on an opposite side of the separation layer with respect to the storage layer, the reference layer having a fixed magnetization direction; and
   an insulator layer sandwiched between the reference layer and the storage layer.
(18) The storage element according to any one of (1) to (17), further including:
   a pair of electrodes sandwiching the stacked structure.
(19) The storage element according to (18),
   in which one of the pair of electrodes includes the second magnetic layer.
(20) A storage device comprising a plurality of storage elements two-dimensionally arranged in an array shape,
   wherein each of the storage elements includes:
   a stacked structure in which a storage layer whose magnetization direction can be reversed, a separation layer, a first magnetic layer, an antiparallel binding layer, and a second magnetic layer are stacked in this order.
(21) The storage device according to (20),
   wherein adjacent second magnetic layers of the second magnetic layers of the plurality of storage elements are connected to each other and provided as an integrated layer.
(22) An electronic device mounted with a storage device comprising a plurality of storage elements two-dimensionally arranged in an array shape,
   wherein each of the storage elements comprises:
   a stacked structure in which a storage layer whose magnetization direction can be reversed, a separation layer, a first magnetic layer, an antiparallel binding layer, and a second magnetic layer are stacked in this order.

### Reference Signs List

2 MEMORY CELL ARRAY
3 MEMORY CELL
7 DETECTION CIRCUIT
8 SELECTION CIRCUIT
10 STORAGE DEVICE
11 VEHICLE CONTROL SYSTEM
21 VEHICLE CONTROL ECU
22 COMMUNICATION UNIT
23 MAP INFORMATION ACCUMULATING UNIT
24 POSITION INFORMATION ACQUIRING UNIT
25 EXTERNAL RECOGNITION SENSOR
26 IN-VEHICLE SENSOR
27 VEHICLE SENSOR
28 STORAGE UNIT
29 TRAVEL ASSISTANCE AND AUTONOMOUS DRIVING CONTROL UNIT
30 DMS
31 HMI
32 VEHICLE CONTROL UNIT
40 SELECTION TRANSISTOR41 SOURCE REGION
42 DRAIN REGION
50 ELEMENT ISOLATION REGION
51 CAMERA
52 RADAR
53 LiDAR
54 ULTRASONIC SENSOR
60 SEMICONDUCTOR SUBSTRATE
61 ANALYSIS UNIT
62 ACTION PLANNING UNIT
63 OPERATION CONTROL UNIT
71 SELF-POSITION ESTIMATION UNIT
72 SENSOR FUSION UNIT
73 RECOGNITION UNIT
80, 908 IMAGING DEVICE
81 STEERING CONTROL UNIT82BRAKE CONTROL UNIT
83 DRIVE CONTROL UNIT
84 BODY SYSTEM CONTROL UNIT
85 LIGHT CONTROL UNIT
86 HORN CONTROL UNIT
87, 88, 89 CHIP
91 VEHICLE
100, 100a MTJ ELEMENT
102 FIXED LAYER
104 NONMAGNETIC LAYER
106 STORAGE LAYER
200 SEPARATION LAYER
202, 206 MAGNETIC LAYER
204 ANTIPARALLEL BINDING LAYER
206a PROTRUDING PORTION
300 MASK
302 INSULATING FILM
500 EXTERNAL MAGNETIC FIELD
641, 906, 941 COMMUNICATION NETWORK
700 CAMERA
710 OPTICAL LENS
712 SHUTTER MECHANISM
714 DRIVE CIRCUIT UNIT
716 SIGNAL PROCESSING CIRCUIT UNIT
900 SMARTPHONE
901 CPU
902 ROM
903 RAM
904 STORAGE DEVICE
905 COMMUNICATION MODULE
907 SENSOR MODULE
910 DISPLAY DEVICE
911 SPEAKER
912 MICROPHONE
913 INPUT DEVICE
914 BUS
1101B, 1101F, 1102B, 1102F, 1102L, 1102R, 1103B, 1103F, 1103L, 1103R, 1105, 1120 SENSING REGION

## Claims

1. A storage element comprising: a stacked structure in which a storage layer whose magnetization direction can be reversed, a separation layer, a first magnetic layer, an antiparallel binding layer, and a second magnetic layer are stacked in this order.

2. The storage element according to claim 1, wherein an area of the second magnetic layer is wider than an area of the first magnetic layer in a cross section taken along a plane perpendicular to a stacking direction of the stacked structure.

3. The storage element according to claim 1, wherein the storage layer, the separation layer, the first magnetic layer, and the antiparallel binding layer have a substantially circular or substantially rectangular shape in a cross section taken along a plane perpendicular to a stacking direction of the stacked structure.

4. The storage element according to claim 3, wherein the second magnetic layer has a substantially circular or substantially rectangular shape in a cross section taken along a plane perpendicular to the stacking direction of the stacked structure.

5. The storage element according to claim 1,
wherein in the stacked structure,
the separation layer is provided on the storage layer,
the first magnetic layer is provided on the separation layer,
the antiparallel binding layer is provided on the first magnetic layer, and
the second magnetic layer is provided on the antiparallel binding layer.

6. The storage element according to claim 5,
wherein the second magnetic layer has a protruding portion protruding downward in the stacking direction of the stacked structure, and
the protruding portion is in contact with the antiparallel binding layer.

7. The storage element according to claim 5, wherein areas of cross sections of the storage layer, the separation layer, the first magnetic layer, and the antiparallel binding layer taken along a plane perpendicular to the stacking direction of the stacked structure decrease in descending order from the storage layer to the antiparallel binding layer.

8. The storage element according to claim 1,
wherein in the stacked structure,
the antiparallel binding layer is provided on the second magnetic layer,
the first magnetic layer is provided on the antiparallel binding layer,
the separation layer is provided on the first magnetic layer, and
the storage layer is provided on the separation layer.

9. The storage element according to claim 8,
wherein the second magnetic layer has a protruding portion protruding upward in the stacking direction of the stacked structure, and
the protruding portion is in contact with the antiparallel binding layer.

10. The storage element according to claim 8, wherein areas of cross sections of the antiparallel binding layer, the first magnetic layer, the separation layer, and the storage layer taken along a plane perpendicular to the stacking direction of the stacked structure decrease in descending order from the storage layer to the antiparallel binding layer.

11. The storage element according to claim 1, wherein the first and second magnetic layers contain at least one ferromagnetic material selected from the group consisting of CoPt, CoNi, CoFeB, CoFe, and NiFe.

12. The storage element according to claim 1, wherein the first and second magnetic layers have a film thickness of greater than or equal to 1 nm and less than 10 nm.

13. The storage element according to claim 1, wherein the antiparallel binding layer contains at least one element selected from the group consisting of Ru, Ir, and Os.

14. The storage element according to claim 1, wherein the antiparallel binding layer has a film thickness of greater than or equal to 3 angstroms and less than 15 angstroms.

15. The storage element according to claim 1, wherein the separation layer contains at least one selected from the group consisting of Cu, Ta, TaN, Ru, Zr, Ir, Cr, W, Mo, Pt, Pd, Al, Si, and CoFeB.

16. The storage element according to claim 1, wherein the separation layer has a film thickness of greater than or equal to 1 nm and less than 10 nm.

17. The storage element according to claim 1,
wherein the stacked structure further includes:
a reference layer provided on an opposite side of the separation layer with respect to the storage layer, the reference layer having a fixed magnetization direction; and
an insulator layer sandwiched between the reference layer and the storage layer.

18. A storage device comprising a plurality of storage elements two-dimensionally arranged in an array shape,
wherein each of the storage elements includes:
a stacked structure in which a storage layer whose magnetization direction can be reversed, a separation layer, a first magnetic layer, an antiparallel binding layer, and a second magnetic layer are stacked in this order.

19. The storage device according to claim 18,
wherein adjacent second magnetic layers of the second magnetic layers of the plurality of storage elements are connected to each other and provided as an integrated layer.

20. An electronic device mounted with a storage device comprising a plurality of storage elements two-dimensionally arranged in an array shape,
wherein each of the storage elements comprises:
a stacked structure in which a storage layer whose magnetization direction can be reversed, a separation layer, a first magnetic layer, an antiparallel binding layer, and a second magnetic layer are stacked in this order.
